# EUROPEAN PATENT APPLICATION

(11) **EP 2 887 223 A1**
(43) Date of publication of application: **24.06.2015**
(21) Application number: 12886312.3
(22) Date of filing: 12.10.2012
(51) Int. Cl.: G06F 13/00

(54) **MEMORY SYSTEM, MEMORY MODULE, MEMORY MODULE ACCESS METHOD AND COMPUTER SYSTEM**

(71) Applicant: Huawei Technologies Co., Ltd., Longgang District Shenzhen, Guangdong 518129 (CN)
(72) Inventor: ZHANG, Lixin, Shenzhen Guangdong 518129 (CN); CHEN, Mingyu, Shenzhen Guangdong 518129 (CN); HUANG, Yongbing, Shenzhen Guangdong 518129 (CN)
(74) Representative: Kreuz, Georg Maria
(86) International application number: PCT/CN2012/082824
(87) International publication number: WO 2014/056178

(57) **Abstract**

Embodiments of the present invention provide a memory system, a memory module, a memory module access method, and a computer system. One or more inter-memory-module interconnection interfaces are added into a memory module, so that a plurality of memory modules in a memory system that separately belong to different memory channels can establish a communication connection through the inter-memory-module interconnection interface, and further, a memory module in the memory system can be accessed by a plurality of memory channels simultaneously. When a load of a certain memory channel is excessively large, accessing a memory module on the memory channel with an excessively large load through another memory channel with a lighter load is implemented, so that a situation that memory channel loads are unbalanced is solved to a certain extent, and a memory channel utilization rate is effectively improved.

## Description

### TECHNICAL FIELD

The present invention relates to the field of computers, and in particular, to a memory system, a memory module, a memory module access method, and a computer system.

### BACKGROUND

Since the end of 1990s, a development speed of a processor technique is about 27% faster than that of a memory technique, so that a computer memory system gradually becomes a bottleneck restricting performance of the entire system, and a "memory wall" also gradually appears. Performance indexes of a memory system mainly are a memory bandwidth and a memory delay. For a memory delay, a reasonable request scheduling policy may be adopted according to a sensitivity level of a different request to a delay to weaken the influence of an access delay on application performance. However, as a request pressure of an application on a memory is continuously increased, a restriction of a memory bandwidth is highlighted. A "memory bandwidth wall" phenomenon summarizes a restriction of a bandwidth of an existing memory system on performance of the entire system.

One or more memory channels may exist in a conventional memory system, these memory channels are managed by a memory controller, each memory channel may support one or more memory slots, a memory module and a memory chip are mounted on each memory slot, an interactive path exists between the memory controller and a memory channel, and between the memory channel and the memory module, and different memory channels and memory modules are independent from each other. In the foregoing conventional memory system, if memory requests are centralized on a certain memory channel, an unbalanced phenomenon that a single memory channel is busy while other memory channels are idle occurs in the memory system.

Additionally, a memory channel and a memory controller comply with a synchronous DDR (Double Date Rate, double data rate) protocol and a time sequence constraint. When a current idle memory module is constrained by a time sequence, the current idle memory module cannot receive a command or transmit data. When a next request accesses the memory module, the memory module cannot return data in time. In this way, an idle phenomenon may occur on a data bus, thereby causing waste of a memory bandwidth resource.

Under the background of the "memory bandwidth wall", a memory bandwidth belongs to a valuable resource, and waste of a bandwidth seems very regrettable. How to improve an effective utilization rate of the memory bandwidth is an important challenge to alleviate a memory system bottleneck.

A main idea of an existing technology for exploring a memory system bandwidth resource is to allocate requests uniformly to each memory channel, each rank, or even each bank, thereby improving a concurrency level of request processing. A high request concurrency level means that requests can be processed simultaneously on a plurality of memory channels, thereby reducing an idle ratio of a memory bus and waste of a memory bandwidth resource. If a memory address is given, a physical location (such as a memory channel number, a rank number, and a bank number) corresponding to the memory address is decided by an address mapping manner of a memory controller. Therefore, a memory address mapping technology directly decides the magnitude of a request parallelism degree. A current memory address mapping technology improves a concurrency level of a memory system by modifying a memory address mapping manner, thereby improving a memory bandwidth utilization rate. However, a modification of the memory address mapping manner depends on a characteristic of an application. A large difference may exist between characteristics of different applications and characteristics of a same application in different periods of time, so that efficiency of modifying the memory address mapping manner is low. Furthermore, the method is applicable to only part of applications, and a certain limitation exists.

### SUMMARY

Embodiments of the present invention provide a memory system, a memory module, a memory module access method, and a computer system, so as to improve a memory channel utilization rate, and alleviating a memory system bottleneck to a certain extent.

In order to achieve the foregoing objectives, the embodiments of the present invention provide the following technical solutions.

In a first aspect, an embodiment of the present invention provides a memory system, and the memory system includes: a first memory module and a second memory module, where the first memory module is provided with a first memory channel interface, and connected to a first memory channel through the first memory channel interface; the second memory module is provided with a second memory channel interface, and connected to a second memory channel through the second memory channel interface; and the first memory module and the second memory module each are further provided with a first inter-memory-module interconnection interface, and the first inter-memory-module interconnection interface of the first memory module and the first inter-memory-module interconnection interface of the second memory module are connected.

In combination with the first aspect, in a first implementation manner, the first memory module is configured to receive or send access data for the memory system through the second memory channel and a connection between the first inter-memory-module interface of the first memory module and the first inter-memory-module interconnection interface of the second memory module; and receive or send access data for the memory system through the first memory channel.

In combination with the first implementation manner of the first aspect, in a second implementation manner, the access data for the memory system includes one or more of the following: an access request for the first memory module, response data or association data of the access request for the first memory module, an access request for the second memory module, and response data or association data of the access request for the second memory module.

In combination with the first aspect or the first implementation manner of the first aspect or the second implementation manner of the first aspect, in a third implementation manner, the first memory module includes a first memory management unit and at least one storage unit, where the first memory management unit is connected to the first inter-memory-module interconnection interface, the first memory channel interface, and the storage unit, and the first memory management unit is configured to: receive access data through the first memory channel interface; determine, according to the access data, whether a destination memory module of the access data is the first memory module; send the access data to the second memory module through the first inter-memory-module interconnection interface, if the destination memory module of the access data is not the first memory module; and determine, according to the access data, a destination storage unit associated with the access data, if the destination memory module of the access data is the first memory module, and execute an operation on the destination storage unit according to the access data, where the destination storage unit is one or more of storage units of the first memory module.

In combination with the third implementation manner of the first aspect, in a fourth implementation manner, the first memory management unit is further configured to: receive access data through the first inter-memory-module interconnection interface, and determine a destination storage unit associated with the access data; and execute an operation on the destination storage unit according to the access data.

In combination with the first implementation manner of the first aspect, in a fifth implementation manner, the memory system further includes a third memory module, where the third memory module is provided with a third channel interface, and the third memory module is connected to a third memory channel through the third channel interface; the first memory module and the third memory module each are further provided with a second inter-memory-module interconnection interface, and the second-inter-memory-module interconnection interface of the first memory module and the second-inter-memory-module interconnection interface of the third memory module are connected; and the first memory module is further configured to receive or send access data for the memory system through the third memory channel and a connection between the second inter-memory-module interconnection interface of the first memory module and the second inter-memory-module interconnection interface of the third memory module.

In combination with the fifth implementation manner of the first aspect, in a sixth implementation manner, the access data for the memory system includes one or more of the following: an access request for the first memory module, response data or association data of the access request for the first memory module, an access request for the second memory module, response data or association data of the access request for the second memory module, an access request for the third memory module, and response data or association data of the access request for the third memory module.

In combination with the fifth implementation manner of the first aspect or the sixth implementation manner of the first aspect, in a seventh implementation manner, the first memory module includes a first memory management unit and at least one storage unit, where the first memory management unit is connected to the first inter-memory-module interconnection interface, the second inter-memory-module interconnection interface, the first memory channel interface, and the storage unit, and the first memory management unit is configured to: receive access data through the first memory channel interface; determine, according to the access data, whether a destination memory module of the access data is the first memory module; determine, according to correspondence between a destination address of the access data and the inter-memory-module interconnection interface, an inter-memory-module interconnection interface corresponding to the access data, if the destination memory module of the access data is not the first memory module; send the access data to the second memory module through the first inter-memory-module interconnection interface, if the inter-memory-module interconnection interface corresponding to the access data is the first inter-memory-module interconnection interface; send the access data to the third memory module through the second inter-memory-module interconnection interface, if the inter-memory-module interconnection interface corresponding to the access data is the second inter-memory-module interconnection interface; and determine, according to the access data, a destination storage unit associated with the access data, if the destination memory module of the access data is the first memory module, and execute an operation on the destination storage unit according to the access data, where the destination storage unit is one or more of storage units of the first memory module.

In a second aspect, an embodiment of the present invention provides a memory module, where the memory module is provided with a memory channel interface and a first inter-memory-module interconnection interface, the memory module includes a memory management unit and at least one storage unit, and the memory management unit is connected to the memory channel interface, the first inter-memory-module interconnection interface, and the storage unit; the memory channel interface is configured to connect to a memory channel; the memory management unit is configured to receive or send access data through the memory channel interface and the memory channel connecting to the memory channel interface; the first inter-memory-module interconnection interface is configured to connect to a first memory module other than the memory module; and the memory management unit is further configured to send or receive access data through the first inter-memory-module interconnection interface and a connection between the memory module and the first memory module.

In combination with the first aspect, in a first implementation manner, the access data includes one or more of the following: an access request for the memory module, response data or association data of the access request for the memory module, an access request for the first memory module, and response data or association data of the access request for the first memory module.

In combination with the second aspect or the first implementation manner of the second aspect, in a second implementation manner, the memory management unit is specifically configured to: receive access data through the memory channel interface and the memory channel; determine, according to the access data, whether a destination memory module of the access data is a current memory module; send the access data to the first memory module through the first inter-memory-module interconnection interface, if the destination memory module of the access data is not the current memory module; and determine, according to the access data, a destination storage unit associated with the access data, if the destination memory module of the access data is the current memory module, and execute an operation on the destination storage unit according to the access data, where the destination storage unit is one or more of storage units of the current memory module.

In combination with the second implementation manner of the second aspect, in a third implementation manner, the memory management unit is further configured to: receive access data through the first inter-memory-module interconnection interface and the connection between the memory module and the first memory module, and determine a destination storage unit associated with the access data; and execute an operation on the destination storage unit according to the access data.

In combination with the second aspect, in a fourth implementation manner, the memory module is further provided with a second inter-memory-module interconnection interface, and the memory management unit is further connected to the second inter-memory-module interconnection interface; the second inter-memory-module interconnection interface is configured to connect to a second memory module other than the memory module and the first memory module; and the memory management unit is further configured to receive or send access data through the second inter-memory-module interconnection interface and a connection between the memory module and the second memory module.

In combination with the fourth implementation manner of the second aspect, in a fifth implementation manner, the access data includes one or more of the following: an access request for the memory module, response data or association data of the access request for the memory module, an access request for the first memory module, response data or association data of the access request for the first memory module, an access request for the second memory module, and response data or association data of the access request for the second memory module.

In combination with the fourth implementation manner of the second aspect or the fifth implementation manner of the second aspect, in a sixth implementation manner, the memory management unit is specifically configured to: receive access data through the memory channel interface; determine, according to the access data, whether a destination memory module of the access data is a current memory module; determine, according to correspondence between a destination address of the access data and the inter-memory-module interconnection interface, an inter-memory-module interconnection interface corresponding to the access data, if the destination memory module of the access data is not the current memory module; send the access data to the first memory module through the first inter-memory-module interconnection interface, if the inter-memory-module interconnection interface corresponding to the access data is the first inter-memory-module interconnection interface; send the access data to the second memory module through the second inter-memory-module interconnection interface, if the inter-memory-module interconnection interface corresponding to the access data is the second inter-memory-module interconnection interface; and determine, according to the access data, a destination storage unit associated with the access data, if the destination memory module of the access data is the current memory module, and execute an operation on the destination storage unit according to the access data, where the destination storage unit is one or more of storage units of the current memory module.

In combination with the sixth implementation manner of the second aspect, in a seventh implementation manner, the memory management unit is further configured to: receive access data through the first inter-memory-module interconnection interface; determine, according to the access data, whether a destination memory module of the access data is a current memory module; send the access data to the second memory module through the second inter-memory-module interconnection interface, if the destination memory module of the access data is not the current memory module; and determine, according to the access data, a destination storage unit associated with the access data, if the destination memory module of the access data is the current memory module, and execute an operation on the destination storage unit according to the access data, where the destination storage unit is one or more of storage units of the current memory module.

In a third aspect, an embodiment of the present invention provides a memory module access method, where the access method includes:receiving a read request through an inter-memory-module interconnection interface, where the inter-memory-module interconnection interface is configured to connect to a memory module other than a current memory module; determining, according to the read request, a destination storage unit associated with the read request, where the destination storage unit is one or more of storage units included in the memory module; reading data stored in the destination storage unit as response data of the read request; and sending the response data of the read request through the inter-memory-module interconnection interface or through a memory channel interface on the memory module.

In combination with the third aspect, in a first implementation manner, when the number of inter-memory-module interconnection interfaces is two or more than two, after the step of receiving a read request through an inter-memory-module interconnection interface, where the inter-memory-module interconnection interface is configured to connect to a memory module other than a current memory module, the method further includes: determining, according to the read request, whether a destination memory module of the read request is the current memory module; sending the read request to another memory module through an inter-memory-module interconnection interface associated with the read request, if the destination memory module of the read request is not the current memory module; and executing the step of determining, according to the read request, a destination storage unit associated with the read request, if the destination memory module of the read request is the current memory module.

In combination with the first implementation manner of the third aspect, in a second implementation manner, the determining, according to the read request, whether a destination memory module of the read request is the current memory module specifically includes: determining whether a destination address of the read request belongs to an address space of the current memory module; or, determining whether a destination address of the read request is an address of the current memory module.

In combination with the first implementation manner of the third aspect or the second implementation manner of the third aspect, in a third implementation manner, the sending the read request to another memory module through an inter-memory-module interconnection interface associated with the read request, if the destination memory module of the read request is not the current memory module specifically includes: querying a routing table of the current memory module according to the destination address of the read request and obtaining an identifier of an inter-memory-module interconnection interface associated with the destination address of the read request, if the destination memory module of the read request is not the current memory module; and sending the read request to the another memory module through an inter-memory-module interconnection interface corresponding to the identifier of the inter-memory-module interconnection interface, where the routing table stores correspondence between an identifier of an inter-memory-module interconnection interface of the current memory module and an address of another memory module connected to the current memory module.

In combination with the first implementation manner of the third aspect or the second implementation manner of the third aspect, in a fourth implementation manner, the sending the read request to another memory module through an inter-memory-module interconnection interface associated with the read request, if the destination memory module of the read request is not the current memory module specifically includes: obtaining an identifier of an inter-memory-module interconnection interface from the destination address of the read request, if the destination memory module of the read request is not the current memory module; and sending the read request to the another memory module through an inter-memory-module interconnection interface corresponding to the identifier of the inter-memory-module interconnection interface.

In combination with the third aspect, in a fifth implementation manner, the method further includes: receiving a write request through an inter-memory-module interconnection interface; receiving association data of the write request through the inter-memory-module interconnection interface; or, receiving association data of the write request through a memory channel interface of the memory module; determining, according to the write request, a destination storage unit associated with the write request; and writing the association data of the write request into the destination storage unit.

In combination with the fifth implementation manner of the third aspect, in a sixth implementation manner, when the number of inter-memory-module interconnection interfaces is two or more than two, after the step of receiving a write request through an inter-memory-module interconnection interface, the method further includes: determining, according to the write request, whether a destination memory module of the write request is the current memory module; sending the write request and the association data of the write request to another memory module through an inter-memory-module interconnection interface associated with the write request, if the destination memory module of the write request is not the current memory module; and executing the step of receiving association data of the write request through the inter-memory-module interconnection interface, if the destination memory module of the write request is the current memory module; or, executing the step of receiving association data of the write request through a memory channel interface of the memory module.

In a fourth aspect, an embodiment of the present invention provides a memory module access method, where the access method includes: receiving an access request through a memory channel interface of a memory module; determining, according to the access request, whether a destination memory module of the access request is a current memory module; and sending the access request to another memory module through an inter-memory-module interconnection interface that is of the current memory module and is associated with the access request, if the destination memory module of the access request is not the current memory module.

In combination with the fourth aspect, in a first implementation manner, the determining, according to the access request, whether a destination memory module of the access request is a current memory module specifically includes: determining whether a destination address of the access request belongs to an address space of the current memory module; or, determining whether a destination address of the access request is an address of the current memory module.

In combination with the fourth aspect or the first implementation manner of the fourth aspect, in a second implementation manner, the sending the access request to another memory module through an inter-memory-module interconnection interface that is of the current memory module and is associated with the access request, if the destination memory module of the access request is not the current memory module specifically includes: querying a routing table of the current memory module according to the destination address of the access request and obtaining an identifier of an inter-memory-module interconnection interface associated with the destination address of the access request, if the destination memory module of the access request is not the current memory module; and sending the access request to the another memory module through an inter-memory-module interconnection interface corresponding to the identifier of the inter-memory-module interconnection interface, where the routing table stores correspondence between an identifier of an inter-memory-module interconnection interface of the current memory module and an address of another memory module connected to the current memory module.

In combination with the fourth aspect or the first implementation manner of the fourth aspect, in a third implementation manner, the sending the access request to another memory module through an inter-memory-module interconnection interface that is of the current memory module and is associated with the access request, if the destination memory module of the access request is not the current memory module specifically includes: obtaining an identifier of an inter-memory-module interconnection interface from the destination address of the access request, if the destination memory module of the access request is not the current memory module; and sending the access request to the another memory module through an inter-memory-module interconnection interface corresponding to the identifier of the inter-memory-module interconnection interface.

In a fifth aspect, an embodiment of the present invention provides a memory module access control method, where the method includes: when a destination address of an access request received by a memory controller is located at a first memory module and a first memory channel accessing the first memory module is busy, sending, by the memory controller, the access request to the first memory module through a second memory channel accessing a second memory module, a second inter-memory-module interconnection interface that is of the second memory module and is configured to connect to the first memory module, and a connection between the second memory module and the first memory module through the second inter- memory-module interconnection interface.

In combination with the fifth aspect, in a first implementation manner, the method further includes: when the destination address of the access request received by the memory controller is located at the second memory module and the second memory channel accessing the second memory module is busy, sending, by the memory controller, the access request to the second memory module through the first memory channel accessing the first memory module, a first inter-memory-module interconnection interface that is of the first memory module and is configured to connect to the second memory module, and a connection between the first memory module and the second memory module through the first inter-memory-module interconnection interface.

In a sixth aspect, an embodiment of the present invention provides a computer system, and the computer system includes: at least one memory controller, a first memory module, and a second memory module, where the memory modules are connected to the memory controller; the first memory module is provided with a first memory channel interface, and connected to a first memory channel through the first memory channel interface; the second memory module is provided with a second memory channel interface, and connected to a second memory channel through the second memory channel interface, the first memory module is connected to the memory controller through the first memory channel, and the second memory module is connected to the memory controller through the second memory channel; and the first memory module and the second memory module each are further provided with a first inter-memory-module interconnection interface, and the first inter-memory-module interconnection interface of the first memory module and the first inter-memory-module interconnection interface of the second memory module are connected.

In combination with the sixth aspect, in a first implementation manner, the first memory module is configured to receive or send access data through the second memory channel and a connection between the first inter-memory-module interface of the first memory module and the first inter-memory-module interconnection interface of the second memory module; and receive or send access data through the first memory channel.

In combination with the first implementation manner of the sixth aspect, in a second implementation manner, the access data includes one or more of the following: an access request for the first memory module, response data or association data of the access request for the first memory module, an access request for the second memory module, and response data or association data of the access request for the second memory module.

In combination with the sixth aspect or the first implementation manner of the sixth aspect or the second implementation manner of the sixth aspect, in a third implementation manner, the first memory module includes a first memory management unit and at least one storage unit, where the first memory management unit is connected to the first inter-memory-module interconnection interface, the first memory channel interface, and the storage unit, and the first memory management unit is configured to: receive access data through the first memory channel interface; determine, according to the access data, whether a destination memory module of the access data is the first memory module; send the access data to the second memory module through the first inter-memory-module interconnection interface, if the destination memory module of the access data is not the first memory module; and determine, according to the access data, a destination storage unit associated with the access data, if the destination memory module of the access data is the first memory module, and execute an operation on the destination storage unit according to the access data, where the destination storage unit is one or more of storage units of the first memory module.

In combination with the third implementation manner of the sixth aspect, in a fourth implementation manner, the first memory management unit is further configured to: receive access data through the first inter-memory-module interconnection interface, and determine a destination storage unit associated with the access data; and execute an operation on the destination storage unit according to the access data.

In combination with the first implementation manner of the sixth aspect, in a fifth implementation manner, the system further includes a third memory module, where the third memory module is provided with a third channel interface, and the third memory module is connected to a third memory channel through the third channel interface; the first memory module and the third memory module each are further provided with a second inter-memory-module interconnection interface, and the second inter-memory-module interconnection interface of the first memory module and the second inter-memory-module interconnection interface of the third memory module are connected; and the first memory module is further configured to receive or send access data for the memory system through the third memory channel and a connection between the second inter-memory-module interconnection interface of the first memory module and the second inter-memory-module interconnection interface of the third memory module.

In combination with the fifth implementation manner of the sixth aspect, in a sixth implementation manner, the access data includes one or more of the following: an access request for the first memory module, response data or association data of the access request for the first memory module, an access request for the second memory module, response data or association data of the access request for the second memory module, an access request for the third memory module, and response data or association data of the access request for the third memory module.

In combination with the fifth implementation manner of the sixth aspect or the sixth implementation manner of the sixth aspect, in a seventh implementation manner, the first memory module includes a first memory management unit and at least one storage unit, where the first memory management unit is connected to the first inter-memory-module interconnection interface, the second inter-memory-module interconnection interface, the first memory channel interface, and the storage unit, and the first memory management unit is configured to: receive access data through the first memory channel interface; determine, according to the access data, whether a destination memory module of the access data is the first memory module; determine, according to correspondence between a destination address of the access data and the inter-memory-module interconnection interface, an inter-memory-module interconnection interface corresponding to the access data, if the destination memory module of the access data is not the first memory module; send the access data to the second memory module through the first inter-memory-module interconnection interface, if the inter-memory-module interconnection interface corresponding to the access data is the first inter-memory-module interconnection interface; and send the access data to the third memory module through the second inter-memory-module interconnection interface, if the inter-memory-module interconnection interface corresponding to the access data is the second inter-memory-module interconnection interface; and determine, according to the access data, a destination storage unit associated with the access data, if the destination memory module of the access data is the first memory module, and execute an operation on the destination storage unit according to the access data, where the destination storage unit is one or more of storage units of the first memory module.

In combination with the sixth aspect or the first implementation manner of the sixth aspect or the second implementation manner of the sixth aspect or the third implementation manner of the sixth aspect or the fourth implementation manner of the sixth aspect, in an eighth implementation manner, the first memory channel is connected to a first memory controller, and the second memory channel is connected to a second memory controller.

In combination with the eighth implementation manner of the sixth aspect, in a ninth implementation manner, the first memory controller is connected to a first processor, and the second memory controller is connected to a second processor; or, the first memory controller is built in a first processor, and the second memory controller is built in a second processor.

In combination with the ninth implementation manner of the sixth aspect, in a tenth implementation manner, the first processor is disposed on a first board, and the second processor is disposed on a second board.

In combination with the ninth implementation manner of the sixth aspect or the tenth implementation manner of the sixth aspect, in an eleventh implementation manner, the first processor and the second processor run different operating systems separately.

It can be known from the foregoing technical solutions that, in the embodiments of the present invention, one or more inter-memory-module interconnection interfaces are added into a memory module, so that a plurality of memory modules in a memory system that separately belong to different memory channels can establish a communication connection through the inter-memory-module interconnection interface, and further, a memory module in the memory system can be accessed by a plurality of memory channels simultaneously. When a load of a certain memory channel is excessively large, accessing a memory module on the memory channel with an excessively large load through another memory channel with a lighter load is implemented, so that a problem that memory channel loads are unbalanced is solved to a certain extent, and a memory channel utilization rate is effectively improved.

### BRIEF DESCRIPTION OF DRAWINGS

To describe the technical solutions in the embodiments of the present invention more clearly, the following briefly introduces the accompanying drawings required for describing the embodiments of the present invention. Apparently, the accompanying drawings in the following description show merely some embodiments of the present invention, and a person of ordinary skill in the art may still derive other drawings from these accompanying drawings without creative efforts.
FIG. 1 is a schematic diagram of a logic structure of a memory system according to an embodiment of the present invention;
FIG. 2a is a schematic diagram of a logic structure of another memory system according to an embodiment of the present invention;
FIG. 2b is a schematic diagram of a logic structure of another memory system according to an embodiment of the present invention;
FIG. 2c is a schematic diagram of a logic structure of another memory system according to an embodiment of the present invention;
FIG. 3a is a schematic diagram of a logic structure of a memory module according to an embodiment of the present invention;
FIG. 3b is a schematic diagram of a logic structure of another memory module according to an embodiment of the present invention;
FIG. 4 is a schematic diagram of a logic structure of another memory system according to an embodiment of the present invention;
FIG. 5 is a schematic diagram of a logic structure of another memory system according to an embodiment of the present invention;
FIG. 6 is a schematic diagram of a logic structure of another memory system according to an embodiment of the present invention;
FIG. 7 is a schematic diagram of a logic structure of another memory system according to an embodiment of the present invention;
FIG. 8 is a schematic flow chart of a memory access method according to an embodiment of the present invention;
FIG. 9 is a schematic flow chart of another memory access method according to an embodiment of the present invention;
FIG. 10a to FIG. 10c are schematic diagrams of implementation of a memory access method according to an embodiment of the present invention;
FIG. 11 is a schematic flow chart of a memory access method according to an embodiment of the present invention;
FIG. 12 is a schematic flow chart of another memory access method according to an embodiment of the present invention;
FIG. 13 is a schematic flow chart of a memory access control method according to an embodiment of the present invention;
FIG. 14 is a schematic diagram of a logic structure of a computer system according to an embodiment of the present invention;
FIG. 15a is a schematic diagram of a local logic structure of a computer system according to an embodiment of the present invention;
FIG. 15b is a schematic diagram of a local logic structure of another computer system according to an embodiment of the present invention;
FIG. 16 is a schematic diagram of a local logic structure of another computer system according to an embodiment of the present invention; and
FIG. 17 is a schematic diagram of a local logic structure of another computer system according to an embodiment of the present invention.

### DESCRIPTION OF EMBODIMENTS

To make the objectives, technical solutions, and advantages of the embodiments of the present invention more comprehensible, the following clearly and completely describes the technical solutions in the embodiments of the present invention with reference to the accompanying drawings in the embodiments of the present invention. Apparently, the embodiments to be described are merely a part rather than all of the embodiments of the present invention. All other embodiments obtained by a person of ordinary skill in the art based on the embodiments of the present invention without creative efforts shall fall within the protection scope of the present invention.

To better understand the technical solutions of the present invention, some technical terms in the embodiments of the present invention are introduced first. A CPU (Central Processing Unit, central processing unit) mentioned in the embodiments of the present invention is one type of processor, and the processor may also be an ASIC (Application Specific Integrated Circuit, application specific integrated circuit), or be configured as one or more integrated circuits for implementing the embodiments of the present invention. Persons skilled in the art may understand that, other implementation manners of the processor may also replace the CPU in the embodiments of the present invention.

A memory controller is an important component for controlling a memory module (or referred to as a memory) and enabling the memory and the processor to exchange data between each other through the memory controller in a computer system. Currently, it is popular that a memory controller is embedded into a CPU, but it may also be that the memory controller and the CPU are implemented separately, and the two communicate through a connection.

A memory module is used to store running data of a processor (such as a CPU), and one memory module generally includes one or more storage units (or referred to as memory chips). A memory channel interface is an interface that is on a memory module and is used to connect to a memory channel. A memory channel is a channel through which a memory module and a memory controller are connected. Generally, one or more memory modules are connected to a memory channel through a memory channel interface, and further connected to a memory controller through the memory channel. Unless explicitly specified, types of the memory channel interface and the memory channel and a transport protocol to be complied with are not limited in the embodiments of the present invention.

Several types of frequently-used memory modules are exemplified in the following. A DIMM (Dual Inline Memory Modules, dual in-line memory module) is a new memory module emerging after the Pentium CPU is launched, and the DIMM provides a 64-bit data channel, so that the DIMM can be used in a single piece on a Pentium mainboard, a slot of the DIMM is longer than that of an SIMM (single in-line memory module, single in-line memory module), and furthermore, the DIMM also supports a new 168-pin EDORAM (Extended Data Output RAM, extended data output RAM) memory. A DRAM (Dynamic Random Access Memory, dynamic random access memory) is a most common memory chip, and one DIMM or SIMM may include one or more DRAMs. A DRAM can maintain data only for a very short time. In order to maintain data, the DRAM performs storage by using a capacitor, and therefore, refreshing has to be done once at intervals, and if a storage unit is not refreshed, stored information is lost. Data stored in the DRAM is also lost after power-off or power-down. An NVM (Non-Volatile Memory, non-volatile memory) is another storage particle that may serves as a memory chip, and one DIMM or SIMM may include one or more NVMs. The NVM is generally used to store a program and data, and its characteristic is different from a characteristic of the DRAM, data stored in the NVM is not lost after power-off or power-down.

Additionally, it should be noted that, the "connection" in the embodiments of the present invention refers to a communication connection between two or more than two virtual modules, between two or more than two physical modules, or between a physical module and a virtual module, and its specific implementation may be one or more communication lines or signal lines. Unless explicitly specified, the "connection" may be a direct connection, may be a connection through an interface or a port, and may also be a connection through another virtual module or physical module. In the embodiments of the present invention, unless explicitly specified, the "first" and the "second" are used only for the purpose of distinguishing, but are not in a specific sequence relationship.

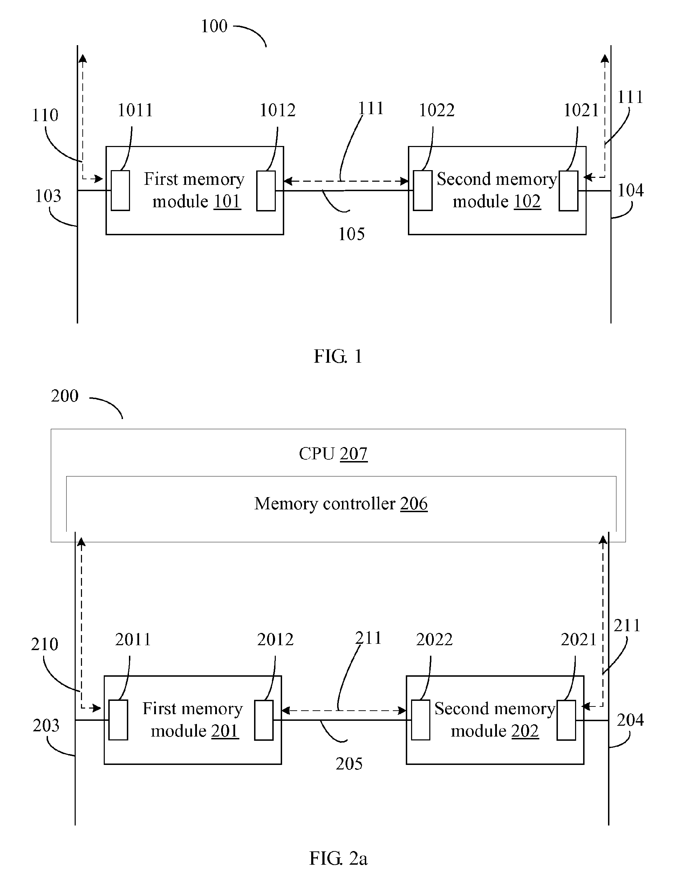

FIG. 1 is a schematic diagram of a logic structure of a memory system according to an embodiment of the present invention. As shown in FIG. 1, the memory system 100 includes: a first memory module 101 and a second memory module 102, where the first memory module 101 is provided with a first memory channel interface 1011, and connected to a first memory channel 103 through the first memory channel interface 1011; the second memory module 102 is provided with a second memory channel interface 1021, and connected to a second memory channel 104 through the second memory channel interface 1021; the first memory module 101 and the second memory module 102 are further provided with a first inter-memory-module interconnection interface 1012 and a second inter-memory-module interconnection interface 1022, the first inter-memory-module interconnection interface 1012 of the first memory module 101 and the second inter-memory-module interconnection interface 1022 of the second memory module 102 are connected, and a connection between the first inter-memory-module interface 1012 of the first memory module 101 and the first inter-memory-module interconnection interface 1022 of the second memory module 102 is shown as 105 in FIG. 1. It should be noted that, the first memory channel 103 and the second memory channel 104 may further be connected to one or more other memory modules.

In some embodiments of the present invention, the first memory module 101 is configured to receive or send access data for the memory system through the second memory channel 104 and the connection between the first inter-memory-module interface 1012 of the first memory module 101 and the first inter-memory interconnection interface 1022 of the second memory module 102; and receive or send access data for the memory system through the first memory channel 103. In some other embodiments of the present invention, the first memory module 101 is configured to receive or send access data for the memory system through a connection between the first inter-memory-module interconnection interface 1012 of the first memory module 101 and an inter-memory-module interconnection interface of another memory module.

The access data for the memory system includes one or more of the following: an access request for the first memory module, response data or association data of the access request for the first memory module, an access request for the second memory module, and response data or association data of the access request for the second memory module. It should be noted that, the access request may be a read request, or may be a write request. When the access request is a read request, the response data of the access request may be data to be read by the read request from the memory system; and when the access request is a write request, the association data of the access request may be data to be written by the write request into the memory system.

In the memory system shown in FIG. 1, the first memory channel 103 forms a path 110 (shown by a dashed line with a bidirectional arrow) for accessing the first memory module 101; the second memory channel 104 and the inter-memory-module communication connection 105 form a path 111 for accessing the first memory module; and the path 110 and the path 111 do not share a physical bus, and specific implementation is that the first memory channel 103 and the second memory channel 104 do not share a physical bus, and therefore, the path 110 and the path 111 can work in parallel. The first memory module 101 not only can receive an access request (the access request may be from a memory controller) through the first memory channel 103, namely, the path 110, but also can receive an access request through the second memory channel 104 and the inter-memory-module communication connection 105, namely, the path 111. Likewise, the second memory module 102 not only can receive an access request through the second memory channel 104, but also can receive an access request through the first memory channel 103 and the inter-memory-module communication connection 105. Association data of an access request or response data of the access request returned by a memory module may also be sent by selecting a proper path according to a path running status (such as busy or idle), and a transmission line of access data is not limited in the embodiment of the present invention, namely, an access request and response data or association data of the access request may be transmitted through a same path, or may be transmitted through different paths.

It should be noted that, in the memory system provided in the embodiment of the present invention, storage media of different memory modules may be different, and may also be the same, which is not limited in the embodiment of the present invention.

FIG. 2a is a schematic diagram of a logic structure of a memory system 200 according to an embodiment of the present invention. 201 to 205, 210, 211, 2011, 2012, 2021, and 2022 in FIG. 2a are the same as 101 to 105, 110, 111, 1011, 1012, 1021, and 1022 in FIG. 1 in meaning respectively, which are not described herein again. FIG. 2a further shows a storage controller 206. A first memory module 201 and a second memory module 202 are connected to the same memory controller 206 through different memory channels.

The memory controller 206 is configured to monitor a running status of a first memory channel 203 and a second memory channel 204; and receive access data for the memory system, and send the access data to the memory system according to the running status of the first memory channel and the second memory channel. In an implementation manner, the running status includes a busy status and an idle status. When a destination address of a received access request is located at the first memory module 201 and the first memory channel 203 is busy, the memory controller 206 transfers the access request to the first memory module 201 through a path 211, namely, sends the access request to the second memory module 202 through the second memory channel 204, and the second memory module 202 sends the access data to the first memory module 201 through a connection 205 between a first inter-memory-module interconnection interface 2022 of the second memory module 202 and a first inter-memory-module interconnection interface 2012 of the first memory module 201. Likewise, when the destination address of the received access request is located at the second memory module 202 and the second memory channel 204 is busy, the memory controller 206 transfers the access request to the first memory module 201 through the first memory channel 203, and the first memory module 201 sends the access data to the second memory module 202 through the connection 205 between the first inter-memory-module interconnection interface 2012 of the first memory module 201 and the first inter-memory-module interconnection interface 2022 of the second memory module 202. In this implementation manner, response data returned according to a read request may be returned through an idle path, or may be returned through a busy path; and association data of a write request and the read request may be sent through a same path, or may be sent through different paths, which is not limited in the embodiment of the present invention.

Further, the memory controller 206 is further configured to record a path of the access data and a status of the access data, where the path of the access data includes the first memory channel or the second memory channel and the status of the access data includes whether the access data is sent. In the embodiment of the present invention, the path of the access request may be a path 210 or the path 211 for accessing the first memory module 201, and definitely may also be a corresponding path for accessing the second memory module 202. The status of the access request includes whether an access request is sent and/or whether a result of an access request is returned.

The memory controller 206 shown in FIG. 2a is embedded into a CPU 207, while in some other embodiments of the present invention, a memory controller may also exist independently of a processor, and the memory controller and the CPU communicate through a physical connection.

In some embodiments of the present invention, the first memory channel is connected to a first memory controller, and the second memory channel is connected to a second memory controller, namely, the first memory channel and the second memory channel may be connected to different memory controllers separately, and the two memory controllers may be embedded into the CPU, or may exist independently of the CPU. In an implementation manner, a communication connection may exist between the two memory controllers. When the first memory channel connected to the first memory controller is busy, an access request may be sent to the second memory controller through the communication connection between the two, so that the second memory controller sends the access request to the second memory module through the second memory channel, and then the second memory module sends the access request to the first memory module through an inter-memory-module interconnection interface. In another implementation manner, if no communication connection exists between the two memory controllers, a module responsible for scheduling may be disposed, a communication connection exists between the module and each of the two memory controllers, the module monitors an idle or busy status of a memory channel or a memory controller sends a status of a memory channel to the module, and the module decides, according to statuses of two (or more) memory channels, which memory controller to which an access request is sent. For a specific scheduling method, reference is made to the foregoing embodiment of the present invention, which is not described herein again.

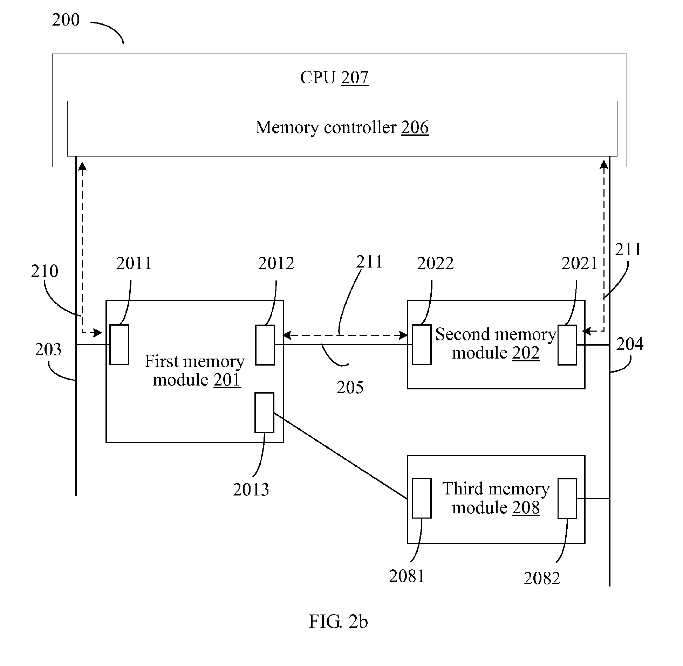

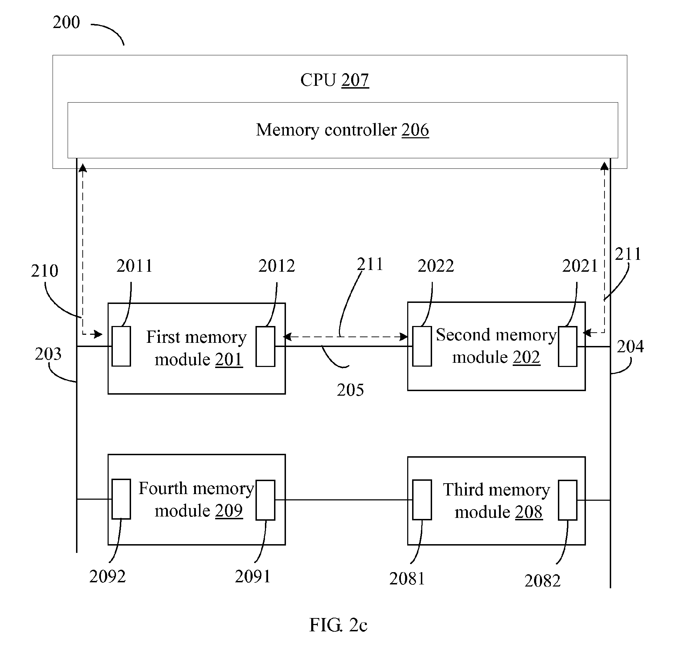

Further, as shown in FIG. 2b, the memory system 200 may further include a third memory module 208. The third memory module 208 is provided with a third channel interface 2082; the third memory module 208 is connected to the second memory channel 204 through the third channel interface 2082; and the first memory module 201 and the third memory module 208 are further provided with a second inter-memory-module interconnection interface 2013 and a second inter-memory-module interconnection interface 2081, and the second inter-memory-module interconnection interface 2013 of the first memory module 201 and the second inter-memory-module interconnection interface 2081 of the third memory module 208 are connected. Compared with the embodiment shown in FIG. 2, in the embodiment shown in FIG. 2b, the first memory module 201 is further configured to receive or send access data for the memory system through the second memory channel 204 and a connection between the second inter-memory-module interconnection interface 2013 of the first memory module 201 and the second inter-memory-module interconnection interface 2081 of the third memory module 208. In some other embodiments of the present invention, a memory channel connected to the third memory module 208 may be a memory channel other than the first memory channel and the second memory channel.

In some other embodiments of the present invention, two or more than two memory channels in a memory system may be connected to two or two memory modules, and a one-to-one, one-to-multiple and/or multiple-to-one connection relationship may be established between the memory modules according to a requirement. For example, as shown in FIG. 2c, the first memory channel 203 is connected to a fourth memory module 209 through a memory channel interface 2092 of the fourth memory module, and the fourth memory module 209 and the third memory module 208 are connected through their respective inter-memory-module interconnection interfaces 2091 and 2081. On the basis of FIG. 2c, the first memory module and the third memory module may also be connected through another inter-memory-module interconnection interface (not shown in the figure).

It should be noted that, in the embodiment of the present invention, storage media of the memory modules may be the same, and may also be different. For example, the first memory module 201 is a DRAM memory module and the second memory module 202 is an NVM memory module or another type of memory module. In the embodiment of the present invention, the memory module may be an independent physical module, and the memory channel interface and the inter-memory-module interconnection interface are physical interfaces. In the embodiment of the present invention, the memory channel interface may be a double rate interface complying with a DDR or DDR2 or DDR3 or DDR4 protocol, and may also be another type of interface complying with another protocol.

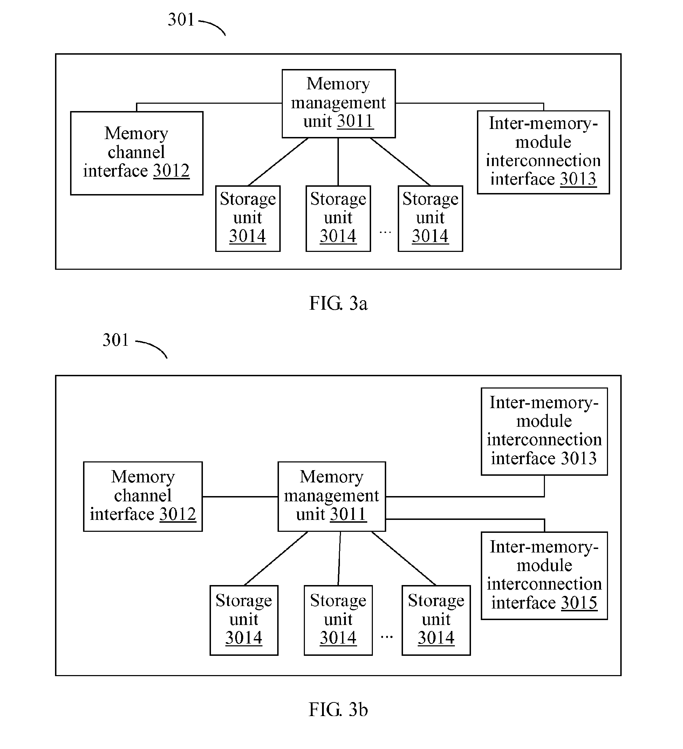

FIG. 3a is a schematic diagram of an internal structure of a memory module 301 according to an embodiment of the present invention. The memory module may be applied to the memory system in the foregoing embodiments of the present invention (such as the first memory module 201 shown in FIG. 1, FIG. 2a, and FIG. 2c), and may also be applied to another memory system. As shown in FIG. 3a, the memory module 301 includes a memory management unit 3011, a memory channel interface 3012, an inter-memory-module interconnection interface 3013 (connected to another memory module), and a plurality of storage units 3014; the memory management unit 3011 is connected to the inter-memory-module interconnection interface 3013, the memory channel interface 3012, and the storage units 3014. The memory channel interface 3012 is configured to connect to a memory channel; the memory management unit 3011 is configured to receive or send access data through the memory channel interface and the memory channel connected to the memory channel interface; the inter-memory-module interconnection interface 3013 is configured to connect to a memory module other than the memory module; and the memory management unit 3011 is further configured to send or receive access data through the inter-memory-module interconnection interface 3013. Specifically, according to FIG. 3a, the memory management unit 3011 is configured to send or receive access data through the inter-memory-module interconnection interface 3013 and a connection between the memory module and the memory module other than the memory module. The access data includes one or more of the following: an access request for the memory module, response data or association data of the access request for the memory module, an access request for the first memory module, and response data or association data of the access request for the first memory module.

As shown in FIG. 3a, the memory management unit 3011 is configured to receive access data through the memory channel interface 3012 and the memory channel; determine, according to the access data, whether a destination memory module of the access data is a current memory module; send the access data to another memory module through the first inter-memory-module interconnection interface 3013, if the destination memory module of the access data is not the current memory module; and determine, according to the access data, a destination storage unit associated with the access data, if the destination memory module of the access data is the current memory module, and execute an operation on the destination storage unit according to the access data, where the destination storage unit is one or more of the storage units 3014 of the current memory module.

In an implementation manner, the step of determining, according to the access data, whether a destination memory module of the access data is a current memory module specifically includes: determining whether a destination address of the access data belongs to an address space of the current memory module; or, determining whether a destination address of the access data is an address of the current memory module. The destination address of the access data is an address of the destination memory module of the access data, and may be a value and may also be a value range. The destination address may be carried by the access data. In another implementation manner, the access data may include an identification bit, where the identification bit is used to identify whether a memory module where the destination address of the access data is located is the current memory module. The identification bit may be implemented as 0 and 1, and if an identification bit of received access data is 0, it is determined that a memory module where a destination address of the access data is located is the current memory module; and if it is 1, it is determined that the memory module where the destination address of the access data is located is not the current memory module.

In some embodiments of the present invention, if the access data is a read request, a read operation is executed on the destination storage unit; and if the access data is a write request, a write operation is executed on the destination storage unit.

The memory management unit 3011 is further configured to: receive access data through the inter-memory-module interconnection interface 3013 and the connection between the memory module 301 and the memory module other than the memory module., and determine a destination storage unit associated with the access data; and execute an operation on the destination storage unit according to the access data.

In some embodiments of the present invention, a memory module may include two or more than two inter-memory-module interconnection interfaces. In this implementation, for access data, such as a read request or a write request, received by one of the inter-memory-module interconnection interfaces, it also needs to determine whether a destination memory module of the access data is a current memory module, because the current memory module may be an intermediate memory module between a previous memory module and a next memory module.

Further, as shown in FIG. 3b, the memory module 301 is further provided with an inter-memory-module interconnection interface 3015, and the memory management unit 3011 is further connected to the inter-memory-module interconnection interface 3015; the inter-memory-module interconnection interface 3015 is configured to connect to a memory module other than the memory module and a memory module that is connected to the inter-memory-module interconnection interface 3013; the memory management unit 3011 is further configured to receive or send access data through the inter-memory-module interconnection interface 3015 and a connection between the inter-memory-module interconnection interface 3015 and the memory module other than the memory module and the memory module that is connected to the inter-memory-module interconnection interface 3013. Two or more than two memory modules connected to the inter-memory-module interconnection interface 3013 and the inter-memory-module interconnection interface 3015 may be connected to a same memory channel, or may be connected to different memory channels. The access data includes one or more of the following: an access request for the memory module, response data or association data of the access request for the memory module, an access request for the first memory module, response data or association data of the access request for the first memory module, an access request for the second memory module, and response data or association data of the access request for the second memory module.

As shown in FIG. 3b, the memory management unit 3011 is specifically configured to: receive access data through the memory channel interface 3012; determine, according to the access data, whether a destination memory module of the access data is a current memory module; determine, according to correspondence between a destination address of the access data and the inter-memory-module interconnection interface, an inter-memory-module interconnection interface corresponding to the access data, if the destination memory module of the access data is not the current memory module; send, to another memory module connected to 3013, the access data through the inter-memory-module interconnection interface 3013, if the inter-memory-module interconnection interface corresponding to the access data is the inter-memory-module interconnection interface 3013; and send, to another memory module connected to 3015, the access data through the inter-memory-module interconnection interface 3015, if the inter-memory-module interconnection interface corresponding to the access data is the inter-memory-module interconnection interface 3015; and determine, according to the access data, a destination storage unit associated with the access data, if the destination memory module of the access data is the current memory module, and execute an operation on the destination storage unit according to the access data, where the destination storage unit is one or more of storage units of the current memory module. For specific implementation, reference is made to the foregoing embodiment, which is not described herein again.

Further, as shown in FIG. 3b, the memory management unit 3011 may further be configured to: receive access data through the inter-memory-module interconnection interface 3013; determine, according to the access data, whether a destination memory module of the access data is a current memory module; send, to another memory module connected to 3015, the access data through the inter-memory-module interconnection interface 3015, if the destination memory module of the access data is not the current memory module; and determine, according to the access data, a destination storage unit associated with the access data, if the destination memory module of the access data is the current memory module, and execute an operation on the destination storage unit according to the access data, where the destination storage unit is one or more of storage units of the current memory module.

It is easily understood by persons skilled in the art that, in the foregoing method, after a memory module receives access data through one of two inter-memory-module interconnection interfaces, whether the access data is forwarded through a memory channel or another inter-memory-module interconnection interface may also be determined. When a memory module has three or more than three inter-memory-module interconnection interfaces, no matter whether access data is received from a memory channel or one of the inter-memory-module interconnection interfaces, which inter-memory-module interconnection interface through which the access data is forwarded needs to be determined through judgment.

In some embodiments of the present invention, the memory module is an independent physical module, and the memory channel interface and the inter-memory-module interconnection interface are physical interfaces. The memory channel interface may be a double data rate DDR or DDR2 or DDR3 or DDR4 interface. The storage unit includes a dynamic random access memory DRAM chip and/or a non-volatile memory NVM chip.

It can be known from the foregoing technical solution that, in the embodiment of the present invention, one or more inter-memory-module interconnection interfaces are added into a memory module, so that a plurality of memory modules in a memory system that separately belong to different memory channels can establish a communication connection through the inter-memory-module interconnection interface, and further, a memory module in the memory system can be accessed by a plurality of memory channels simultaneously. When a load of a certain memory channel is excessively large, accessing a memory module on the memory channel with an excessively large load through another memory channel with a lighter load is implemented, so that a situation that memory channel loads are unbalanced is solved to a certain extent, and a memory channel utilization rate is effectively improved.

Additionally, with the technical solution provided in the embodiment of the present invention, a connection can be established between memory modules connected to different memory controllers, between different memory modules connected to different CPUs, or even between memory modules of different boards, different cabinets, or different computer systems, to form a memory area network, where the memory area network can be shared by different memory controllers, different CPUs, different boards, different cabinets, or different computer systems. Topology formed by the connection between memory modules may be set by setting the number of interconnection interfaces on a memory module and a connection relationship between the interconnection interfaces on the memory module according to a requirement. The following description is made through some specific implementation manners.

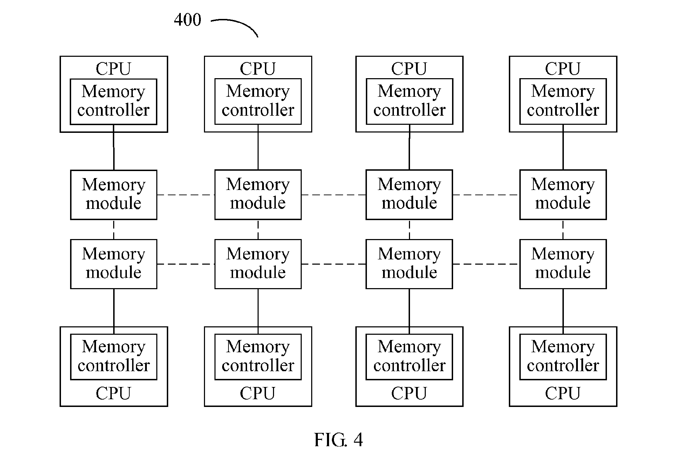

FIG. 4 is a schematic diagram of a logic structure of a memory system 400 according to an embodiment of the present invention. As shown in FIG. 4, different CPUs each include a memory controller (the embodiment of the present invention is described by taking that a memory controller is embedded into a CPU as an example, and in actual implementation, a memory controller and a CPU may also be implemented separately), the memory controller is connected to a memory module through a memory channel (shown by a solid line connection in the figure), and memory modules of CPUs are connected through inter-memory-module interconnection interfaces (not shown in the figure). Solid lines in FIG. 4 show memory channels between memory controllers and their respective memory modules, and dashed lines are connections established between memory modules through inter-memory-module interconnection interfaces. It can be seen from FIG. 4 that, memory modules separately belonging to different CPUs form a memory area network by establishing an interconnection, each CPU can access each memory module in the entire memory area network through a memory channel connected to the CPU, and the memory area network may be transparent for a single CPU or memory controller.

In FIG. 4, a plurality of memory modules may specifically be implemented as DIMM or SIMM modules, where each memory module may internally include one or more DRAMs as storage units, or include one or more NVMs as storage units. Storage media inside the memory modules may be in a same type, and may also be in different types, which is not limited in the embodiment of the present invention. A communication connection between memory modules may be implemented as a high-speed bus, where the high-speed bus may be an asynchronous serial bus and may also be a synchronous parallel bus. If the high-speed bus is an asynchronous serial bus, a data unit transmitted in the bus may be a message packet. A form of the message packet is flexible, and content in the message packet, such as a command and data, may be configured.

A plurality of CPUs shown in FIG. 4 may be wholly or partially located in one computer system, or may belong to different computer systems separately. In the latter case, a CPU may be regarded as a server node, different server nodes may be located at different physical locations, a network delay and a bandwidth of server nodes at different physical locations may be different, performance parameters and magnitudes of network influence of different server nodes are also different, and characteristics of different applications also have different requirements for memory performance. Therefore, a form of the memory area network may be set according to a different requirement, and an organization of the memory area network may be a grid network shown in FIG. 4, may also be a hierarchical or semi-hierarchical network, and may also be a centralized network. For memory area networks in different organization forms, reference may be made to memory module structures introduced in other embodiments in this specification, and on the basis of this, persons of ordinary skill in the art may perform implementation by adjusting the number of inter-memory-module interconnection interfaces, a connection relationship between memory modules, and a routing function in a memory module.

It can be seen that, after an inter-memory-module interconnection is implemented, different server nodes can share memory resources of an entire system conveniently and quickly. For a phenomenon that loads of different server memories are unbalanced, memory data may be rapidly moved and deployed between different nodes through a high-speed memory area network. The memory resources of the system may be transparently shared in a virtual global memory address space formed in the memory area network. Additionally, if data exchange, such as an operation of data duplication, needs to be performed between different nodes, the memory area network can directly and rapidly complete a data operation without a conventional set of procedure such as a memory controller, an operating system, and a network protocol stack.

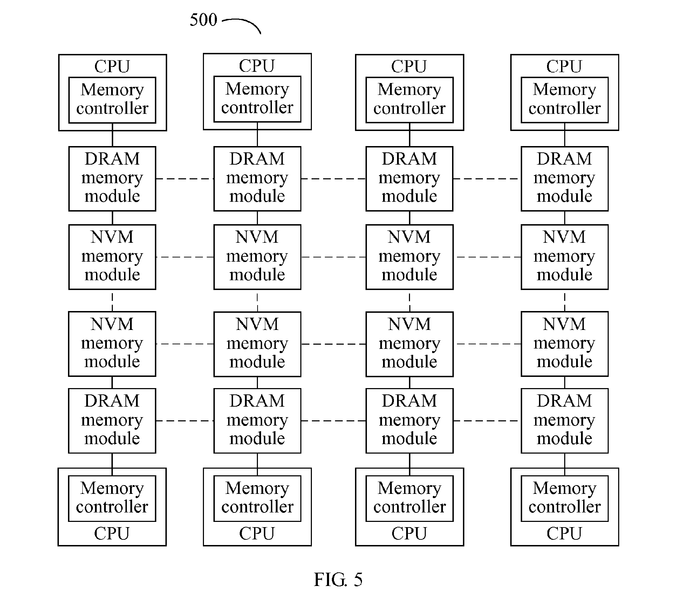

FIG. 5 is a schematic diagram of a logic structure of a memory system 500 formed by different storage media according to an embodiment of the present invention. Each memory controller is connected to one DRAM memory module and one NVM memory module through a memory channel (shown by a solid line connection in FIG. 5). One or more storage units (or referred to as "memory chips") in the DRAM memory module use a DRAM storage medium, and one or more storage units in the NVM memory module use an NVM storage medium. DRAM memory modules and NVM modules of different memory controllers are provided with inter-memory-module interconnection interfaces, and a connection relationship shown by dashed lines in FIG. 5 is established through these interfaces. For specific implementation of the DRAM memory module and the NVM memory module, reference may be made to any memory module embodiment of the present invention and any transformed implementation manner that persons skilled in the art can learn accordingly.

In some other embodiments of the present invention, the DRAM memory module and the NVM memory module shown in FIG. 5 may be connected to a same memory controller through memory channel interfaces and memory channels complying with different protocols.

In the embodiment shown in FIG. 5, according to different manners for using the DRAM memory module and the NVM memory module, a connection relationship between memory modules also differs. In an implementation manner, if an NVM memory module is only used as data backup of a DRAM memory module, a frequency and a bandwidth of a line used for a connection between the DRAM memory module and the NVM memory module may not be extremely high; and in another implementation manner, if an NVM memory module is used as a part of a DRAM memory module, a frequency and a bandwidth of a line used for a connection between the DRAM memory module and the NVM memory module have to meet specific frequency and bandwidth requirements.

Compared with the memory system shown in FIG. 4, an NVM memory module is added into the memory system shown in FIG. 5. The DRAM memory module and the NVM memory module have respective advantages and disadvantages in aspects such as capacity, delay, bandwidth, power consumption, and durability. In FIG. 5, these memory modules with different storage media are connected together as a memory area network, and characteristics of various storage media can be fully utilized, so as to maximize advantages of the memory system in aspects such as capacity, delay, and power consumption.

It should be noted that, in specific implementation, a memory module type other than a DRAM and an NVM may also be selected, and there may be two or more than two hybrid types. A connection relationship between memory modules may be implemented as a grid network shown in FIG. 5, or a hierarchical or semi-hierarchical network, or a centralized network.

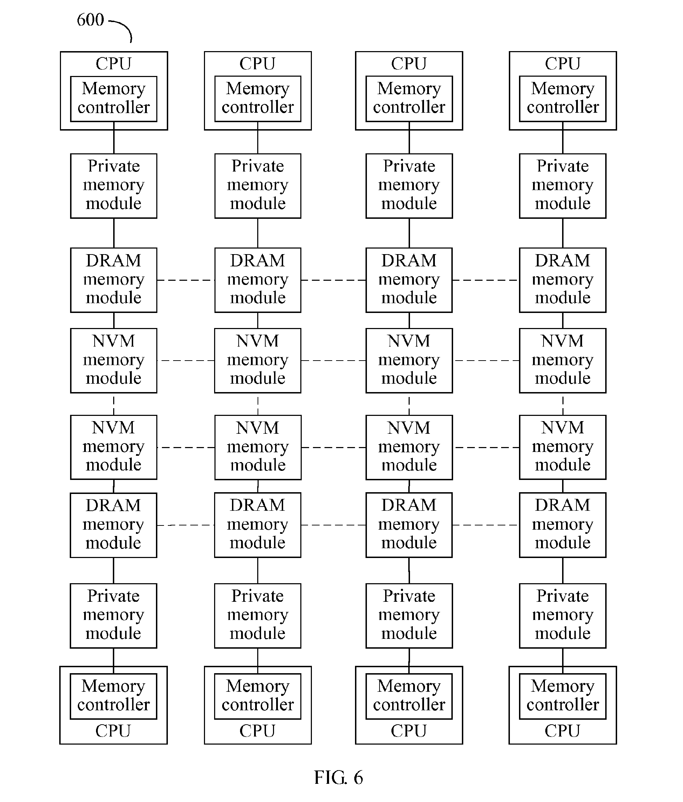

FIG. 6 is a schematic diagram of a logic structure of another memory system 600 according to an embodiment of the present invention. On the basis of the foregoing embodiment shown in FIG. 5, in the memory system shown in FIG. 6, each CPU has its own private memory module, and the private memory module may be implemented as a DIMM memory module or another type of memory module. Private memory modules of different CPUs may be in a same type and may also be in different types. The private memory module is not provided with an inter-memory-module interconnection interface, and is connected to a memory controller only through a memory channel (shown by a solid line connection in the figure), and therefore, the private memory module cannot be accessed by another memory module or another memory controller or CPU.

Each CPU is connected to its own private memory module and a memory area network. The memory area network is shared by all processors to a certain extent, shared memory modules may be constrained in aspects such as capacity, delay, and bandwidth, and the private memory module of each CPU may be configured to satisfy an exclusive requirement of the CPU for a memory to a certain extent. The private memory module of each CPU may be configured to store frequently-accessed core data of each CPU, and it does not need to worry that a memory bandwidth and capacity are influenced by another CPU.

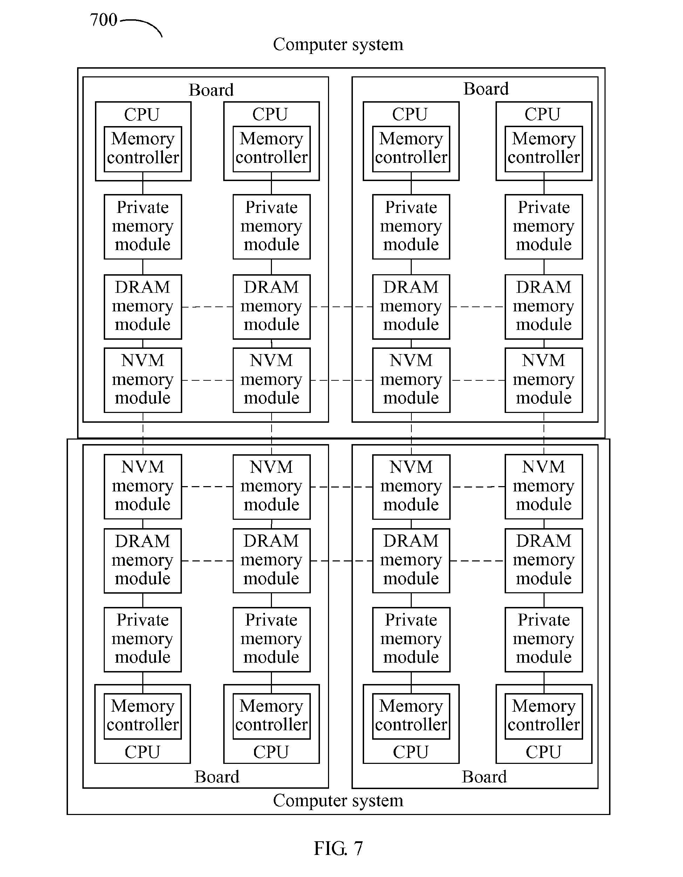

FIG. 7 is a schematic diagram of a logic structure of a memory system according to an embodiment of the present invention. As shown in FIG. 7, eight CPUs are located on four boards (which may also be motherboards or mainboards) in pairs, and every two boards belong to one computer system. These two boards may be located at a same cabinet or may be located at different cabinets. Memory modules in different computer systems except private memory modules can be shared through the memory system provided in the embodiment of the present invention.

It can be seen from the description of the foregoing embodiments that, in the present invention, memory modules are organized in a multi-dimensional manner, and in addition to a connection between a memory module and a memory controller, a connection between memory modules further exists. A memory module not only can be accessed by a memory controller in a conventional memory channel manner, but also can be accessed by another memory module, and further by another memory channel through a connection in another dimension, thereby changing a conventional one-dimensional memory organization form and a phenomenon, which is caused by the conventional one-dimensional memory organization form, that memory channels cannot coordinate between each other, so that memory buses of all memory channels are fully utilized, and a utilization rate of a memory bus bandwidth is improved.

An access manner of a memory module in a memory system provided in the present invention is introduced in the following through some specific embodiments.

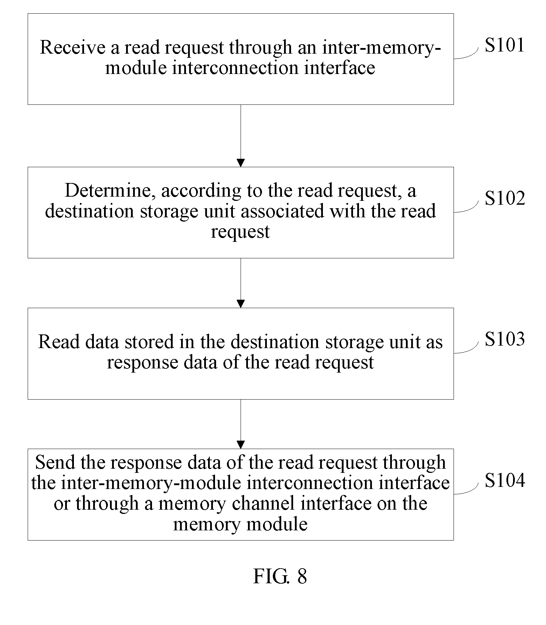

FIG. 8 is a schematic flow chart of a memory module access method according to an embodiment of the present invention. The method may be applied to a memory system provided in the embodiment of the present invention, the memory system includes two or more than two memory modules, where the memory module includes a memory channel interface and at least one inter-memory-module interconnection interface, and for an implementation manner of the memory module, reference may be made to the description in the foregoing embodiment. As shown in FIG. 8, the method includes:

S101: Receive a read request through an inter-memory-module interconnection interface, where the inter-memory-module interconnection interface is configured to connect to a memory module other than a current memory module.

S102: Determine, according to the read request, a destination storage unit associated with the read request, where the destination storage unit is one or more of storage units included in the memory module.

S103: Read data stored in the destination storage unit as response data of the read request.

S104: Send the response data of the read request through the inter-memory-module interconnection interface or through a memory channel interface on the memory module.

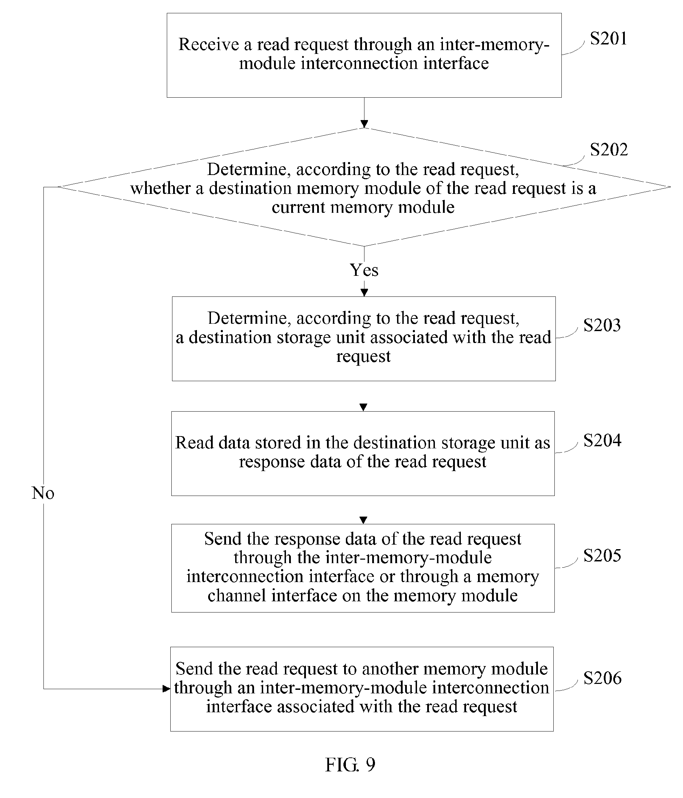

Further, when the number of inter-memory-module interconnection interfaces is two or more than two, as shown in FIG. 9, an embodiment of the present invention provides another memory system access method, and the method includes:

S201: Receive a read request through an inter-memory-module interconnection interface, where the inter-memory-module interconnection interface is configured to connect to a memory module other than a current memory module.

S202: Determine, according to the read request, whether a destination memory module of the read request is the current memory module; send the read request to another memory module through an inter-memory-module interconnection interface associated with the read request, if the destination memory module of the read request is not the current memory module (S206); and execute step S203, if the destination memory module of the read request is the current memory module.

Step S203, step S204, and step S205 are the same as step S102, step S103, and step S104 shown in FIG. 8 respectively, which are not described herein again.

Specifically, step S202 may be implemented as follows: determining whether a destination address of the read request belongs to an address space of the current memory module; or, determining whether a destination address of the read request is an address of the current memory module. If the destination address of the read request belongs to the address space of the current memory module, or, the destination address of the read request is the address of the current memory module, a determination result is yes; and if the destination address of the read request does not belong to the address space of the current memory module, and the destination address of the read request is not the address of the current memory module, a determination result is no.

In an implementation manner, step S206 specifically is: querying a routing table of the current memory module according to the destination address of the read request and obtaining an identifier of an inter-memory-module interconnection interface associated with the destination address of the read request; and sending the read request to the another memory module through an inter-memory-module interconnection interface corresponding to the identifier of the inter-memory-module interconnection interface, where the routing table stores correspondence between an identifier of an inter-memory-module interconnection interface of the current memory module and an address of another memory module connected to the current memory module.

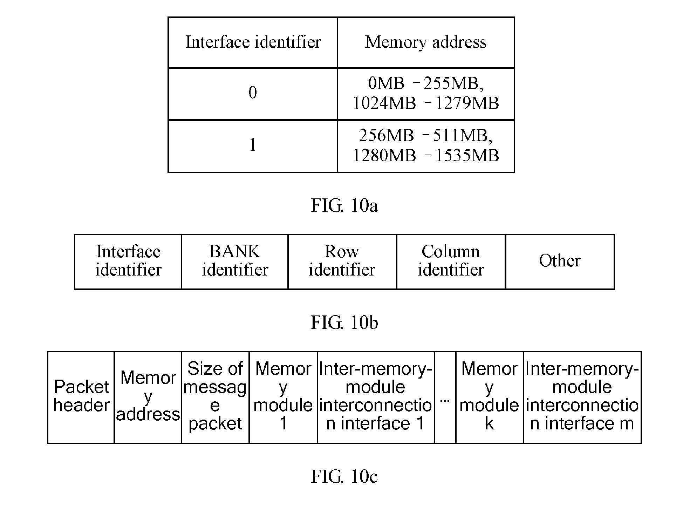

As shown in FIG. 10a, correspondence between interface identifiers of different interfaces and a memory address is maintained in a memory management module, and is referred to as a routing table in the following. A first column in the routing table stores interface identifiers of two inter-memory-module interconnection interfaces in a memory module, and 1 and 2 identify an inter-memory-module interconnection interface 1 and an inter-memory-module interconnection interface 2 respectively; and a second column is a memory address space corresponding to an inter-memory-module interconnection interface, a memory address space corresponding to each interface may be a consecutive address space, and may also be a plurality of inconsecutive address spaces, for example, may be an address range space of 0MB - 255MB and an address range space of 1024MB - 1279MB.

In another implementation manner, step S206 specifically is: obtaining an identifier of an inter-memory-module interconnection interface from the destination address of the read request; and sending the read request to the another memory module through an inter-memory-module interconnection interface corresponding to the identifier of the inter-memory-module interconnection interface.

FIG. 10b is an exemplary diagram of a destination address carried in an access request. The destination address includes an interface identifier, a bank identifier, a row identifier, a column identifier, and other information. The bank identifier, the row identifier, and the column identifier are general identifiers in a memory address well known by persons skilled in the art, while other information is information extended according to a requirement, which is not described herein again. It should be noted that, the interface identifier is used to identify an interface to which the access request needs to be routed, and may be an identifier of a memory channel interface, and may also be an identifier of an inter-memory-module interconnection interface.

In another implementation manner, step S206 specifically is: obtaining an identifier of an inter-memory-module interconnection interface directly from an access request, and then forwarding this access request to an inter-memory-module interconnection interface corresponding to this identifier of the inter-memory-module interconnection interface.

If an interconnection between memory modules adopts an asynchronous serial bus, a data unit transmitted in the bus may be a message packet, a form of the message packet is flexible, and content in the message packet, such as a command and data, may be configured. FIG. 10c is an example of a form of a message packet of an access request in an embodiment of the present invention, and the message packet includes a packet header, a memory address, a size of the message packet, and a memory module and an inter-memory-module interconnection interface to which the message packet needs to be routed. It can be seen from FIG. 10c that, the message packet is routed out from an inter-memory-module interconnection interface 1 of a memory module 1, and finally routed by an inter-memory-module interconnection interface m of a memory module k to a memory module connected to this inter-memory-module interconnection interface m. Therefore, a memory management unit 601 may obtain an identifier of an inter-memory-module interconnection interface directly from the message packet, and route the message packet to a corresponding inter-memory-module interconnection interface; then a memory management unit of a next memory module may also continue to perform routing in the same manner until the message packet reaches a real destination memory module, and determine, according to the memory address, which one or more storage units of the destination memory module need to be accessed.

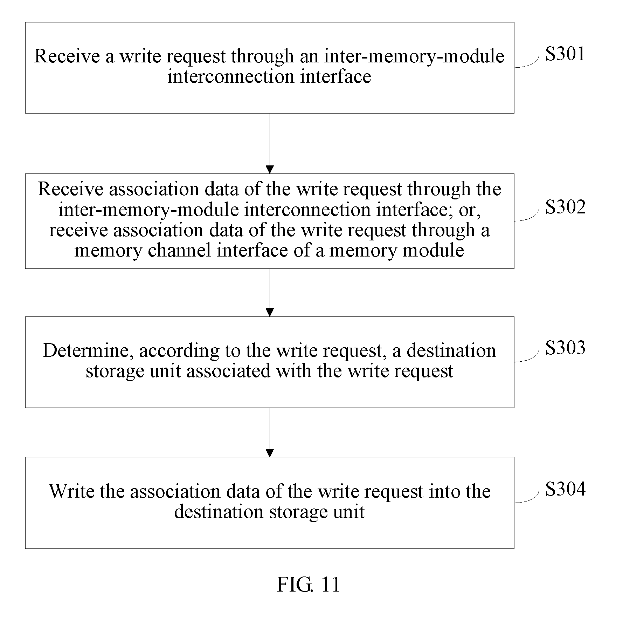

Further, as shown in FIG. 11, a memory module access method provided in an embodiment of the present invention may further include:

S301: Receive a write request through an inter-memory-module interconnection interface.

S302: Receive association data of the write request through the inter-memory-module interconnection interface; or, receive association data of the write request through a memory channel interface of a memory module.

S303: Determine, according to the write request, a destination storage unit associated with the write request.

S304: Write the association data of the write request into the destination storage unit.

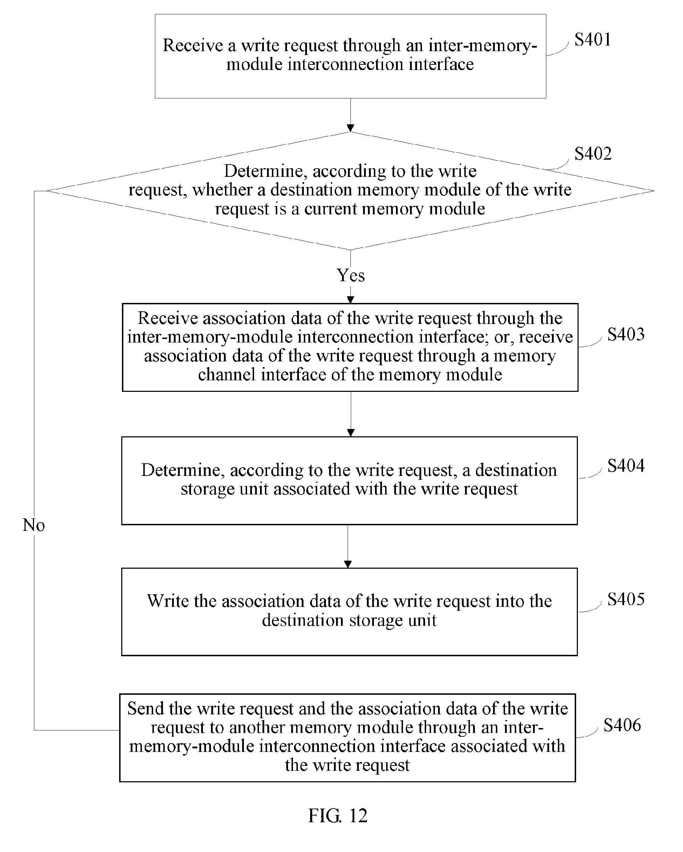

When the number of inter-memory-module interconnection interfaces is two or more than two, as shown in FIG. 12, the method includes:

S401: Receive a write request through an inter-memory-module interconnection interface.

S402: Determine, according to the write request, whether a destination memory module of the write request is a current memory module. For a specific determining method, reference may be made to the foregoing determining method of the read request.

If the destination memory module of the write request is not the current memory module, step S406 is executed: sending the write request and the association data of the write request to another memory module through an inter-memory-module interconnection interface associated with the write request.

If the destination memory module of the write request is the current memory module, step S403 is executed.

Step S403, step S404, and step S405 are similar to step S302, step S303, and step S304 in the foregoing embodiment, which are not described herein again.

It is easily understood by persons skilled in the art that, in the embodiment of the present invention, a write request and association data of the write request may be received through a same transmission line or may be received through different transmission lines; and the write request and the association data of the write request may be forwarded through a same transmission line or may be forwarded through different lines, and whether the write request and the association data of the write request are transmitted through a same path is not limited. For a process of determining a destination memory module of a write request, reference may be made to the foregoing embodiment of the read request, which is not described herein again.

Additionally, it should be noted that, step S301 to step S304 or step S401 to step S406 and step S101 to S104 or step S201 to step S206 have no specific sequence relationship. A memory module may execute step S101 to step S104 or step S201 to step S206 if a read request is received, and may execute step S301 to step S304 or step S401 to step S406 if a write request is received.

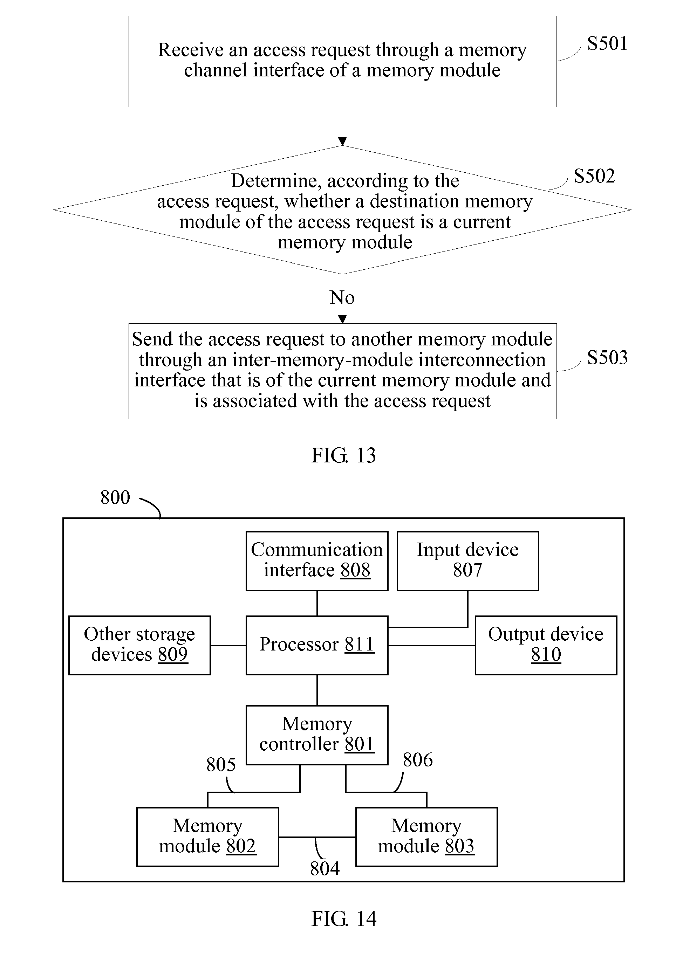

FIG. 13 is a schematic flow chart of another memory module access method according to an embodiment of the present invention. The method includes:

S501: Receive an access request through a memory channel interface of a memory module.

S502: Determine, according to the access request, whether a destination memory module of the access request is a current memory module; and execute step S503, if the destination memory module of the access request is not the current memory module.

Specifically, step S502 may be implemented as follows: determining whether a destination address of the access request belongs to an address space of the current memory module; or, determining whether a destination address of the access request is an address of the current memory module.

S503: Send the access request to another memory module through an inter-memory-module interconnection interface that is of the current memory module and is associated with the access request.

In an implementation manner, step S503 is specifically implemented as follows: querying a routing table of the current memory module according to the destination address of the access request and obtaining an identifier of an inter-memory-module interconnection interface associated with the destination address of the access request; and sending the access request to the another memory module through an inter-memory-module interconnection interface corresponding to the identifier of the inter-memory-module interconnection interface, where the routing table stores correspondence between an identifier of an inter-memory-module interconnection interface of the current memory module and an address of another memory module connected to the current memory module.

In another implementation manner, step S503 is specifically implemented as follows: obtaining an identifier of an inter-memory-module interconnection interface from the destination address of the access request; and sending the access request to the another memory module through an inter-memory-module interconnection interface corresponding to the identifier of the inter-memory-module interconnection interface.

If the destination memory module of the access request is the current memory module, an execution manner is similar to that in the foregoing embodiment.

An embodiment of the present invention further provides a memory module access control method, and the method may be applied to a memory controller. The method includes:
when a destination address of an access request received by a memory controller is located at a first memory module and a first memory channel accessing the first memory module is busy, sending, by the memory controller, the access request to the first memory module through a second memory channel accessing a second memory module, a second inter-memory-module interconnection interface that is of the second memory module is configured to connect to the first memory module, and a connection between the second memory module and the first memory module through the second inter-memory-module interconnection interface.

Further, the method may further include:
when the destination address of the access request received by the memory controller is located at the second memory module, and the second memory channel accessing the second memory module is busy, sending, by the memory controller, the access request to the second memory module through the first memory channel accessing the first memory module, a first inter-memory-module interconnection interface that is of the first memory module and is configured to connect to the second memory module, and a connection between the first memory module and the second memory module through the first inter-memory-module interconnection interface.

It can be known from the foregoing technical solution that, in the memory access method and the memory access control method provided in the embodiments of the present invention, a memory module can be accessed by a plurality of memory channels simultaneously. When a load of a certain memory channel is excessively large, accessing a memory module on the memory channel with an excessively large load through another memory channel with a lighter load is implemented, so that a situation that memory channel loads are unbalanced is solved to a certain extent, and a memory channel utilization rate is effectively improved.

FIG. 14 is a schematic diagram of a logic structure of a computer system 800 according to an embodiment of the present invention. The computer system includes: a processor 811, a memory controller 801, an output device 810 (a display and a display screen), an input device 809 (such as a keyboard, a mouse, and a touch screen), and a communication interface 808, where the memory controller are connected to two memory modules 802 and 803 through two memory channels 805 and 806. A connection 804 exists between the memory module 802 and the memory module 803, and the memory module 802 not only can receive, through the memory channel 805 connected to the memory module 802, access data sent by the memory controller 801, but also can receive, through the connection 804 between the memory module 802 and the memory module 803 and through the memory channel 806 connected to the memory module 803, access data sent by the memory controller. The communication interface 808 is an interface through which the computer system is connected to a network, may be a network card interface of an ordinary computer or an antenna interface of a mobile phone terminal, and is configured to communicate with another computer system, which specifically includes data sending and reception. In addition to a memory, the computer system may further include a storage device 805 in another type, such as a cache or magnetic disk.

In some other embodiments of the present invention, a bus connection structure may be adopted in the computer system, for example, a processor, a memory controller, and a communication interface can be connected together through a bus. The bus may be an ISA (Industry Standard Architecture, industry standard architecture) bus, a PCI (Peripheral Component, peripheral component interconnect) bus, or an EISA (Extended Industry Standard Architecture, extended industry standard architecture) bus. The bus may be one or more physical lines, and when the bus is a plurality of physical lines, the physical lines may be classified into an address bus, a data bus, a control bus, and the like.

In some other embodiments of the present invention, the memory controller 801 may be built in the processor 804.

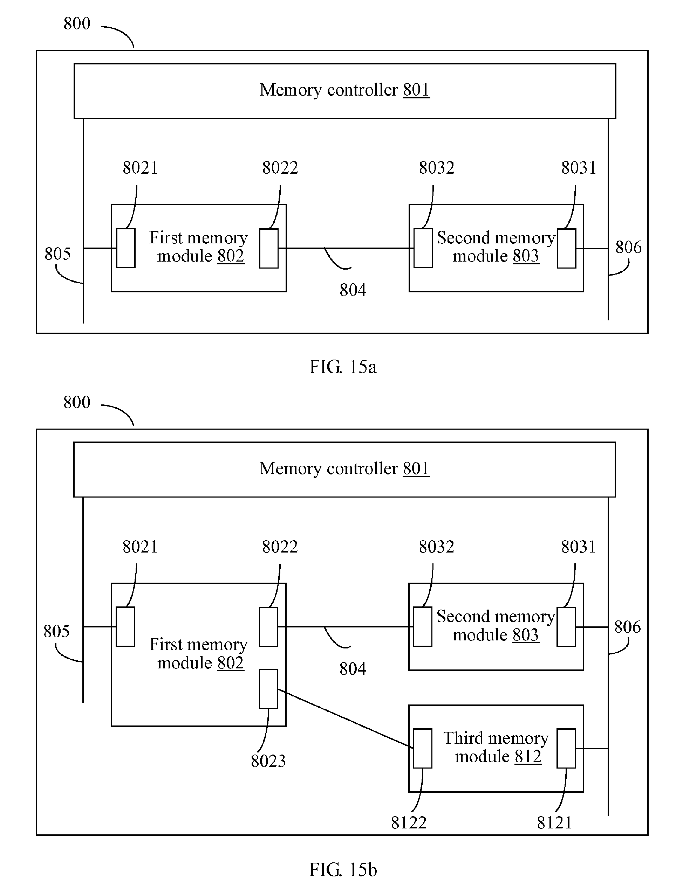

FIG. 15a is a schematic diagram of a local logic structure of a computer system 800 according to an embodiment of the present invention, where the computer system includes: a memory controller 801, a first memory module 802, and a second memory module 803, where the two memory modules are both connected to the memory controller 801; the first memory module 802 is provided with a first memory channel interface 8021, and connected to a first memory channel 805 through the first memory channel interface 8021; the second memory module 803 is provided with a second memory channel interface 8031, and connected to a second memory channel 806 through the second memory channel interface 8031; the first memory module 802 is connected to the memory controller 801 through the first memory channel 805 and the second memory module 803 is connected to the memory controller 801 through the second memory channel 806; and the first memory module 802 and the second memory module 803 are further provided with a first inter-memory-module interconnection interface 8022 and a first inter-memory-module interconnection interface 8032 respectively, and 8022 and 8032 are connected.

The first memory module 802 is configured to receive or send access data through the second memory channel 806 and a connection between the first inter-memory-module interface 8022 of the first memory module 802 and the first inter-memory-module interconnection interface 8032 of the second memory module 803, and receive or send access data through the first memory channel 805. The access data includes one or more of the following: an access request for the first memory module 802, response data or association data of the access request for the first memory module 802, an access request for the second memory module 803, and response data or association data of the access request for the second memory module 803.

Specifically, the first memory module 802 includes a first memory management unit and at least one storage unit, where the first memory management unit is connected to the first inter-memory-module interconnection interface, the first memory channel interface 8021, and the storage unit, and the first memory management unit is configured to: receive access data through the first memory channel interface 8021; determine, according to the access data, whether a destination memory module of the access data is the first memory module 802; send the access data to the second memory module 803 through the first inter-memory-module interconnection interface 8022, if the destination memory module of the access data is not the first memory module 802; and determine, according to the access data, a destination storage unit associated with the access data, if the destination memory module of the access data is the first memory module 802, and execute an operation on the destination storage unit according to the access data, where the destination storage unit is one or more of storage units of the first memory module 802. Further, the first memory management unit is further configured to: receive access data through the first inter-memory-module interconnection interface 8022, and determine a destination storage unit associated with the access data; and execute an operation on the destination storage unit according to the access data.

Further, referring to FIG. 15b, the computer system may further include a third memory module 812, where the third memory module 812 is provided with a third channel interface 8121, and the third memory module 812 is connected to the second memory channel 806 through the third channel interface 8121; the first memory module 802 and the third memory module 812 are further provided with a second inter-memory-module interconnection interface 8023 and a second inter-memory-module interconnection interface 8122 respectively, and the second inter-memory-module interconnection interface 8023 of the first memory module 802 and the second inter-memory-module interconnection interface 8122 of the third memory module 812 are connected; and the first memory module 802 is further configured to receive or send access data for the memory system through the second memory channel 806 and a connection between the second inter-memory-module interconnection interface 8022 of the first memory module 802 and the second inter-memory-module interconnection interface 8122 of the third memory module 812.

In some other embodiments of the present invention, the third memory module 812 may also be connected to a memory channel other than the first memory channel 805 and the second memory channel 806 through the third channel interface 8121. Protocols with which memory channels among the three modules comply may be the same, and may also be different, which is not limited in the embodiment of the present invention.

The access data includes one or more of the following: an access request for the first memory module 802, response data or association data of the access request for the first memory module 802, an access request for the second memory module 803, response data or association data of the access request for the second memory module 803, an access request for the third memory module 812, and response data or association data of the access request for the third memory module 812. In this implementation manner, the first memory module 802 includes a first memory management unit and at least one storage unit, where the first memory management unit is connected to the first inter-memory-module interconnection interface 8022, the second inter-memory-module interconnection interface 8023, the first memory channel interface 8021, and the storage unit, and the first memory management unit is configured to: receive access data through the first memory channel interface 8021; determine, according to the access data, whether a destination memory module of the access data is the first memory module 802; determine, according to correspondence between a destination address of the access data and the inter-memory-module interconnection interface, an inter-memory-module interconnection interface corresponding to the access data, if the destination memory module of the access data is not the first memory module 802; send the access data to the second memory module 803 through the first inter-memory-module interconnection interface 8022, if the inter-memory-module interconnection interface corresponding to the access data is the first inter-memory-module interconnection interface 8022; and send the access data to the third memory module through the second inter-memory-module interconnection interface 8023, if the inter-memory-module interconnection interface corresponding to the access data is the second inter-memory-module interconnection interface 8023; and determine, according to the access data, a destination storage unit associated with the access data, if the destination memory module of the access data is the first memory module 802, and execute an operation on the destination storage unit according to the access data, where the destination storage unit is one or more of storage units of the first memory module 802.

In the embodiment of the present invention, the memory controller 801 is configured to monitor a running status of the first memory channel 805 and the second memory channel 806; and receive access data for the memory system, and send the access data to the memory system according to the running status of the first memory channel 805 and the second memory channel 806.

Specifically, the memory controller 801 is configured to monitor the running status of the first memory channel 805 and the second memory channel 806, where the running status includes a busy status and an idle status. When a destination address of the received access data is located at the first memory module 802 and the first memory channel 805 is busy, the memory controller sends the access data to the second memory module 803 through the second memory channel 806, and the second memory module 803 sends the access data to the first memory module 802 through the connection between the first inter-memory-module interconnection interface 8032 of the second memory module 803 and the first inter-memory-module interconnection interface 8022 of the first memory module 802; and when the destination address of the received access data is located at the second memory module 803 and the second memory channel 806 is busy, the memory controller sends the access data to the first memory module 802 through the first memory channel 805, and the first memory module 802 sends the access data to the second memory module 803 through the connection between the first inter-memory-module interconnection interface 8022 of the first memory module 802 and the first inter-memory-module interconnection interface 8032 of the second memory module 803.

Further, the memory controller 801 is further configured to record a path of the access data and a status of the access data, where the path of the access data includes the first memory channel or the second memory channel and the status of the access data includes whether the access data is sent and/or whether a result of an access request is returned.

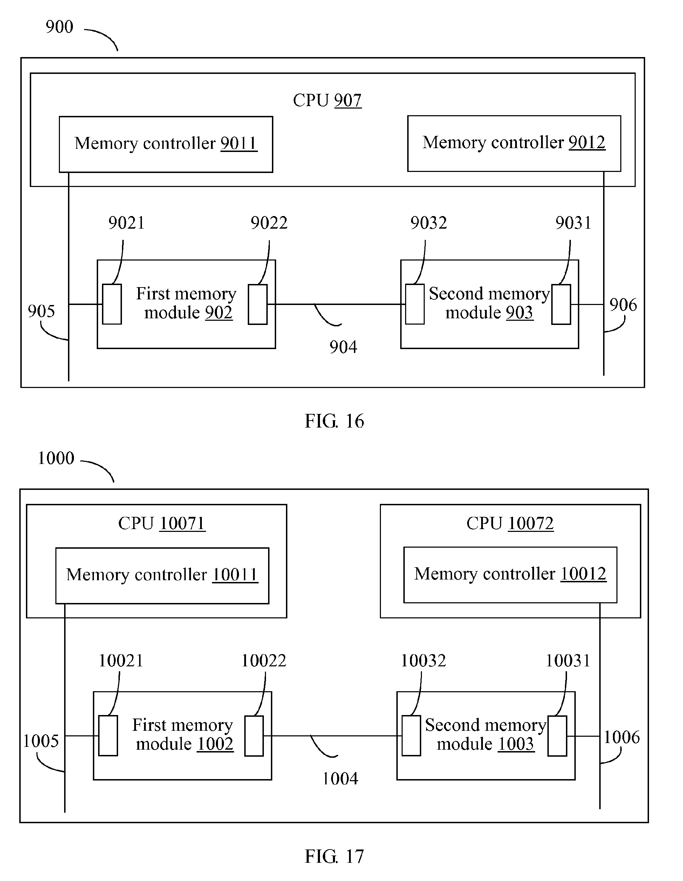

FIG. 16 is a schematic diagram of a local logic structure of another computer system according to an embodiment of the present invention. As shown in FIG. 16, the computer system 900 includes two memory controllers 9011 and 9012, and the two are connected to two memory channels 905 and 906 respectively. The memory controllers 9011 and 9012 are both built in a same CPU 907. In another implementation manner, the memory controllers 9011 and 9012 may also be connected to the CPU 907 instead of being built in the CPU 907. 902, 903, 904, 9021, 9022, 9031 and 9032 in FIG. 16 are similar to 802, 803, 804, 8021, 8022, 8031 and 8032 in FIG. 15a respectively, which are not described herein again.

FIG. 17 is a schematic diagram of a local logic structure of another computer system according to an embodiment of the present invention. As shown in FIG. 17, the computer system 1000 includes two CPUs 10071 and 10072, and the CPU 10071 and the CPU 10072 are internally built with a memory controller 10011 and a memory controller 10012 respectively. The CPU 10071 and the CPU 10072 may run a same operating system or may run different operating systems. 1002, 1003, 1004, 10021, 10022, 10031, and 10032 in FIG. 17 are similar to 902, 903, 904, 9021, 9022, 9031, and 9032 in FIG. 16 respectively, which are not described herein again. In FIG. 17, each independent CPU may be independently connected to one communication interface.

It should be noted that, in some other embodiments of the present invention, each memory channel of a computer system may be connected to two or more than two memory modules. For example, the memory channel 805 may be still further connected to two or more than two memory modules. A connection relationship between memory modules may be set according to a requirement. For specific implementation of a memory module, reference may be made to the description of the foregoing embodiments and the accompanying drawings thereof.

In other embodiments of the present invention, the number of memory controllers in a computer system may also be more than two, and likewise the number of CPUs may be two or more than two. A connection relationship between a plurality of memory modules may be established according to a specific requirement, to form a grid, hierarchical or semi-hierarchical, or centralized memory area network, and for a specific structure, reference may be made to the description of the foregoing embodiments. Additionally, the memory system shown in FIG. 1 and FIG. 2a to FIG. 2c may be wholly or partially included in the computer system provided in the embodiment of the present invention.

It should be noted that, storage media of memory modules in the computer system provided in the embodiment of the present invention may be the same, and may also be different. A memory module may be an independent physical module, and a memory channel interface and an inter-memory-module interconnection interface may be physical interfaces. Specifically, the memory channel interface may be a double data rate DDR interface or DDR2 interface or DDR3 interface or DDR4 interface.

Additionally, the computer system in the embodiment of the present invention may include one board or a plurality of boards, different CPUs may be located on a same board or different boards, and different boards may be located at a same cabinet or may be located at different cabinets. Therefore, the computer system intended to be protected in the present invention is described only by taking FIG. 14 to FIG. 17 as an example, and is not limited thereto.

It can be seen that, in the computer system provided in the embodiment of the present invention, one or more inter-memory-module interconnection interfaces are added into a memory module, so that a plurality of memory modules in a memory system that separately belong to different memory channels can establish a communication connection through the inter-memory-module interconnection interface, and further, a memory module in the memory system can be accessed by a plurality of memory channels simultaneously. When a load of a certain memory channel is excessively large, accessing a memory module on the memory channel with an excessively large load through another memory channel with a lighter load is implemented, so that a situation that memory channel loads are unbalanced is solved to a certain extent, and a memory channel utilization rate is effectively improved.

The embodiments in the specification are described in a progressive manner, and reference may be made to same and similar parts of the embodiments. For example, for function implementation of some modules in the apparatus embodiment, reference may be made to the description of the method in the method embodiment.

It should be noted that, the foregoing apparatus embodiments are merely exemplary, and the units described as separate components may be or may not be physically separated. Components shown as units may be or may not be physical units, that is, may be located in one place or may be distributed to a plurality of network units. Apart of or all of the modules may be selected according to an actual need to achieve the objectives of the solutions of the embodiments. Additionally, in the accompanying drawings of the apparatus embodiments provided in the present invention, a connection relationship between modules indicates that a communication connection exists between the modules, which may specifically be implemented as one or more communication buses or signal lines. Persons of ordinary skill in the art may understand and implement the present invention without creative efforts.

Through the descriptions of the foregoing implementation manners, persons skilled in the art may clearly understand that the present invention may be implemented by dedicated hardware including a dedicated integrated circuit, a dedicated CPU, a dedicated memory, and a dedicated component. A specific hardware structure used to implement a same function may be diversified, such as an analog circuit, a digital circuit, or a dedicated circuit. The present invention may also be implemented through computer software plus necessary hardware. The computer software product is stored in a readable storage medium, for example, a floppy disk, a USB flash disk, a mobile hard disk, a read-only memory (ROM, Read-Only Memory), a random access memory (RAM, Random Access Memory), a magnetic disk, or an optical disk of a computer, and includes several instructions for instructing a computer device (which may be a personal computer, a server, or a network device) to execute the methods described in the embodiments of the present invention.

The foregoing descriptions are merely specific embodiments of the present invention, but are not intended to limit the protection scope of the present invention. Any variation or replacement readily figured out by persons skilled in the art within the technical scope disclosed in the present invention shall all fall within the protection scope of the present invention. Therefore, the protection scope of the present invention shall be subject to the protection scope of the claims.

## Claims

1. A memory system, comprising: a first memory module and a second memory module, wherein the first memory module is provided with a first memory channel interface, and connected to a first memory channel through the first memory channel interface; the second memory module is provided with a second memory channel interface, and connected to a second memory channel through the second memory channel interface; and the first memory module and the second memory module each are further provided with a first inter-memory-module interconnection interface, and the first inter-memory-module interconnection interface of the first memory module and the first inter-memory-module interconnection interface of the second memory module are connected.

2. The system according to claim 1, wherein the first memory module is configured to receive or send access data for the memory system through the second memory channel and a connection between the first inter-memory-module interface of the first memory module and the first inter-memory-module interconnection interface of the second memory module; and receive or send access data for the memory system through the first memory channel.

3. The system according to claim 2, wherein the access data for the memory system comprises one or more of the following: an access request for the first memory module, response data or association data of the access request for the first memory module, an access request for the second memory module, and response data or association data of the access request for the second memory module.

4. The system according to any one of claims 1 to 3, wherein the first memory module comprises a first memory management unit and at least one storage unit, wherein the first memory management unit is connected to the first inter-memory-module interconnection interface, the first memory channel interface, and the storage unit, and the first memory management unit is configured to:
receive access data through the first memory channel interface;
determine, according to the access data, whether a destination memory module of the access data is the first memory module;
send the access data to the second memory module through the first inter-memory-module interconnection interface, if the destination memory module of the access data is not the first memory module; and
determine, according to the access data, a destination storage unit associated with the access data, if the destination memory module of the access data is the first memory module, and execute an operation on the destination storage unit according to the access data, wherein the destination storage unit is one or more of storage units of the first memory module.

5. The system according to claim 4, wherein the first memory management unit is further configured to: receive access data through the first inter-memory-module interconnection interface, and determine a destination storage unit associated with the access data; and execute an operation on the destination storage unit according to the access data.

6. The system according to claim 2, wherein the memory system further comprises a third memory module, wherein the third memory module is provided with a third channel interface; the first memory module and the third memory module each are further provided with a second inter-memory-module interconnection interface, and the second inter-memory-module interconnection interface of the first memory module and the second inter-memory-module interconnection interface of the third memory module are connected;
the third memory module is connected to the second memory channel or a third memory channel through the third channel interface; and
the first memory module is further configured to receive or send access data for the memory system through the third memory channel and a connection between the second inter-memory-module interconnection interface of the first memory module and the second inter-memory-module interconnection interface of the third memory module.

7. The system according to claim 6, wherein the access data for the memory system comprises one or more of the following: an access request for the first memory module, response data or association data of the access request for the first memory module, an access request for the second memory module, response data or association data of the access request for the second memory module, an access request for the third memory module, and response data or association data of the access request for the third memory module.

8. The system according to claim 6 or 7, wherein the first memory module comprises a first memory management unit and at least one storage unit, wherein the first memory management unit is connected to the first inter-memory-module interconnection interface, the second inter-memory-module interconnection interface, the first memory channel interface, and the storage unit, and the first memory management unit is configured to:
receive access data through the first memory channel interface;
determine, according to the access data, whether a destination memory module of the access data is the first memory module;
determine, according to correspondence between a destination address of the access data and the inter-memory-module interconnection interface, an inter-memory-module interconnection interface corresponding to the access data, if the destination memory module of the access data is not the first memory module; send the access data to the second memory module through the first-inter-memory-module interconnection interface, if the inter-memory-module interconnection interface corresponding to the access data is the first inter-memory-module interconnection interface; and send the access data to the third memory module through the second-inter-memory-module interconnection interface, if the inter-memory-module interconnection interface corresponding to the access data is the second inter-memory-module interconnection interface; and
determine, according to the access data, a destination storage unit associated with the access data, if the destination memory module of the access data is the first memory module, and execute an operation on the destination storage unit according to the access data, wherein the destination storage unit is one or more of storage units of the first memory module.

9. The system according to any one of claims 1 to 5, wherein the first memory channel and the second memory channel are connected to a same memory controller.

10. The system according to claim 9, wherein the memory controller is configured to:
monitor a running status of the first memory channel and the second memory channel; and
receive access data for the memory system, and send the access data to the memory system according to the running status of the first memory channel and the second memory channel.

11. The system according to claim 10, wherein the memory controller is specifically configured to:
monitor the running status of the first memory channel and the second memory channel, wherein the running status comprises a busy status and an idle status;
when a destination address of the received access data is located at the first memory module and the first memory channel is busy, the memory controller sends the access data to the second memory module through the second memory channel, and the second memory module sends the access data to the first memory module through the connection between the first inter-memory-module interconnection interface of the second memory module and the first inter-memory-module interconnection interface of the first memory module; and
when the destination address of the received access data is located at the second memory module and the second memory channel is busy, the memory controller sends the access data to the first memory module through the first memory channel, and the first memory module sends the access data to the second memory module through the connection between the first inter-memory-module interconnection interface of the first memory module and the first inter-memory-module interconnection interface of the second memory module.

12. The system according to claim 10 or 11, wherein the memory controller is further configured to: record a path of the access data and a status of the access data, wherein the path of the access data comprises the first memory channel or the second memory channel and the status of the access data comprises whether the access data is sent and/or whether a result of an access request is returned.

13. The system according to any one of claims 1 to 5, wherein the first memory channel is connected to a first memory controller and the second memory channel is connected to a second memory controller.

14. The system according to claim 13, wherein the first memory controller is connected to a first processor and the second memory controller is connected to a second processor; or, the first memory controller is built in a first processor and the second memory controller is built in a second processor.

15. The system according to claim 14, wherein the first processor is disposed on a first board and the second processor is disposed on a second board.

16. The system according to claim 15, wherein the first board and the second board are built in different computer systems separately.

17. The system according to any one of claims 1 to 16, wherein storage media of different memory modules are different; or, storage media of different memory modules are the same.

18. The system according to any one of claims 1 to 17, wherein the memory module is an independent physical module, and the memory channel interface and the inter-memory-module interconnection interface are physical interfaces.

19. The system according to any one of claims 1 to 18, wherein the memory channel interface is a double data rate DDR interface or DDR2 interface or DDR3 interface or DDR4 interface.

20. A memory module, wherein the memory module is provided with a memory channel interface and a first inter-memory-module interconnection interface, the memory module comprises a memory management unit and at least one storage unit, and the memory management unit is connected to the memory channel interface, the first inter-memory-module interconnection interface, and the storage unit;
the memory channel interface is configured to connect to a memory channel;
the memory management unit is configured to receive or send access data through the memory channel interface and the memory channel connecting to the memory channel interface; and
the first inter-memory-module interconnection interface is configured to connect to a first memory module other than the memory module; and the memory management unit is further configured to send or receive access data through the first inter-memory-module interconnection interface.

21. The memory module according to claim 20, wherein the access data comprises one or more of the following: an access request for the memory module, response data or association data of the access request for the memory module, an access request for the first memory module, and response data or association data of the access request for the first memory module.

22. The memory module according to claim 20 or 21, wherein the memory management unit is specifically configured to: receive access data through the memory channel interface and the memory channel; determine, according to the access data, whether a destination memory module of the access data is a current memory module; send the access data to the first memory module through the first inter-memory-module interconnection interface, if the destination memory module of the access data is not the current memory module; and determine, according to the access data, a destination storage unit associated with the access data, if the destination memory module of the access data is the current memory module, and execute an operation on the destination storage unit according to the access data, wherein the destination storage unit is one or more of storage units of the current memory module.

23. The memory module according to claim 22, wherein the memory management unit is further configured to: receive access data through the first inter-memory-module interconnection interface and a connection between the memory module and the first memory module, and determine a destination storage unit associated with the access data; and execute an operation on the destination storage unit according to the access data.

24. The memory module according to claim 20, wherein the memory module is further provided with a second inter-memory-module interconnection interface, and the memory management unit is further connected to the second inter-memory-module interconnection interface; and
the second inter-memory-module interconnection interface is configured to connect to a second memory module other than the memory module and the first memory module; and the memory management unit is further configured to receive or send access data through the second inter-memory-module interconnection interface and a connection between the memory module and the second memory module.

25. The memory module according to claim 24, wherein the access data comprises one or more of the following: an access request for the memory module, response data or association data of the access request for the memory module, an access request for the first memory module, response data or association data of the access request for the first memory module, an access request for the second memory module, and response data or association data of the access request for the second memory module.

26. The memory module according to claim 24 or 25, wherein the memory management unit is specifically configured to:
receive access data through the memory channel interface;
determine, according to the access data, whether a destination memory module of the access data is a current memory module;
determine, according to correspondence between a destination address of the access data and the inter-memory-module interconnection interface, an inter-memory-module interconnection interface corresponding to the access data, if the destination memory module of the access data is not the current memory module; send the access data to the first memory module through the first inter-memory-module interconnection interface, if the inter-memory-module interconnection interface corresponding to the access data is the first inter-memory-module interconnection interface; and send the access data to the second memory module through the second inter-memory-module interconnection interface, if the inter-memory-module interconnection interface corresponding to the access data is the second inter-memory-module interconnection interface; and
determine, according to the access data, a destination storage unit associated with the access data, if the destination memory module of the access data is the current memory module, and execute an operation on the destination storage unit according to the access data, wherein the destination storage unit is one or more of storage units of the current memory module.

27. The memory module according to claim 26, wherein the memory management unit is further configured to:
receive access data through the first inter-memory-module interconnection interface;
determine, according to the access data, whether a destination memory module of the access data is a current memory module;
send the access data to the second memory module through the second inter-memory-module interconnection interface, if the destination memory module of the access data is not the current memory module; and
determine, according to the access data, a destination storage unit associated with the access data, if the destination memory module of the access data is the current memory module, and execute an operation on the destination storage unit according to the access data, wherein the destination storage unit is one or more of storage units of the current memory module.

28. The memory module according to any one of claims 20 to 27, wherein the memory module is an independent physical module, and the memory channel interface and the inter-memory-module interconnection interface are physical interfaces.

29. The memory module according to any one of claims 20 to 28, wherein the memory channel interface is a double data rate DDR or DDR2 or DDR3 or DDR4 interface.

30. The memory module according to any one of claims 20 to 29, wherein the storage unit comprises a dynamic random access memory DRAM chip and/or a non-volatile memory NVM chip.

31. A memory module access method, comprising:
receiving a read request through an inter-memory-module interconnection interface, wherein the inter-memory-module interconnection interface is configured to connect to a memory module other than a current memory module;
determining, according to the read request, a destination storage unit associated with the read request, wherein the destination storage unit is one or more of storage units comprised in the current memory module;
reading data stored in the destination storage unit as response data of the read request; and
sending the response data of the read request through the inter-memory-module interconnection interface or through a memory channel interface on the memory module.

32. The method according to claim 31, wherein when the number of inter-memory-module interconnection interfaces is two or more than two, after the step of receiving a read request through an inter-memory-module interconnection interface, the method further comprises:
determining, according to the read request, whether a destination memory module of the read request is the current memory module;
sending the read request to another memory module through an inter-memory-module interconnection interface associated with the read request, if the destination memory module of the read request is not the current memory module; and
executing the step of determining, according to the read request, a destination storage unit associated with the read request, if the destination memory module of the read request is the current memory module.

33. The method according to claim 32, wherein the determining, according to the read request, whether a destination memory module of the read request is the current memory module specifically comprises:
determining whether a destination address of the read request belongs to an address space of the current memory module; or, determining whether a destination address of the read request is an address of the current memory module.

34. The method according to claim 32 or 33, wherein the sending the read request to another memory module through an inter-memory-module interconnection interface associated with the read request, if the destination memory module of the read request is not the current memory module specifically comprises:
querying a routing table of the current memory module according to the destination address of the read request and obtaining an identifier of an inter-memory-module interconnection interface associated with the destination address of the read request, if the destination memory module of the read request is not the current memory module; and
sending the read request to the another memory module through an inter-memory-module interconnection interface corresponding to the identifier of the inter-memory-module interconnection interface, wherein
the routing table stores correspondence between an identifier of an inter-memory-module interconnection interface of the current memory module and an address of another memory module connected to the current memory module.

35. The method according to claim 32 or 33, wherein the sending the read request to another memory module through an inter-memory-module interconnection interface associated with the read request, if the destination memory module of the read request is not the current memory module specifically comprises:
obtaining an identifier of an inter-memory-module interconnection interface from the destination address of the read request, if the destination memory module of the read request is not the current memory module; and sending the read request to the another memory module through an inter-memory-module interconnection interface corresponding to the identifier of the inter-memory-module interconnection interface.

36. The method according to claim 31, further comprising:
receiving a write request through an inter-memory-module interconnection interface;
receiving association data of the write request through the inter-memory-module interconnection interface; or, receiving association data of the write request through a memory channel interface of the memory module;
determining, according to the write request, a destination storage unit associated with the write request; and
writing the association data of the write request into the destination storage unit.

37. The method according to claim 36, wherein when the number of inter-memory-module interconnection interfaces is two or more than two, after the step of receiving a write request through an inter-memory-module interconnection interface, the method further comprises:
determining, according to the write request, whether a destination memory module of the write request is the current memory module;
sending the write request and the association data of the write request to another memory module through an inter-memory-module interconnection interface associated with the write request, if the destination memory module of the write request is not the current memory module; and
executing the step of receiving association data of the write request through the inter-memory-module interconnection interface, if the destination memory module of the write request is the current memory module; or, executing the step of receiving association data of the write request through a memory channel interface of the memory module.

38. A memory module access method, comprising:
receiving an access request through a memory channel interface of a memory module;
determining, according to the access request, whether a destination memory module of the access request is a current memory module; and
sending the access request to another memory module through an inter-memory-module interconnection interface that is of the current memory module and is associated with the access request, if the destination memory module of the access request is not the current memory module.

39. The method according to claim 38, wherein the determining, according to the access request, whether a destination memory module of the access request is a current memory module specifically comprises:
determining whether a destination address of the access request belongs to an address space of the current memory module; or, determining whether a destination address of the access request is an address of the current memory module.

40. The method according to claim 38 or 39, wherein the sending the access request to another memory module through an inter-memory-module interconnection interface that is of the current memory module and is associated with the access request, if the destination memory module of the access request is not the current memory module specifically comprises:
querying a routing table of the current memory module according to the destination address of the access request and obtaining an identifier of an inter-memory-module interconnection interface associated with the destination address of the access request, if the destination memory module of the access request is not the current memory module; and
sending the access request to the another memory module through an inter-memory-module interconnection interface corresponding to the identifier of the inter-memory-module interconnection interface, wherein
the routing table stores correspondence between an identifier of an inter-memory-module interconnection interface of the current memory module and an address of another memory module connected to the current memory module.

41. The method according to claim 38 or 39, wherein the sending the access request to another memory module through an inter-memory-module interconnection interface that is of the current memory module and is associated with the access request, if the destination memory module of the access request is not the current memory module specifically comprises:
obtaining an identifier of an inter-memory-module interconnection interface from the destination address of the access request, if the destination memory module of the access request is not the current memory module; and sending the access request to the another memory module through an inter-memory-module interconnection interface corresponding to the identifier of the inter-memory-module interconnection interface.

42. A memory module access control method, comprising:
when a destination address of an access request received by a memory controller is located at a first memory module and a first memory channel accessing the first memory module is busy, sending, by the memory controller, the access request to the first memory module through a second memory channel accessing a second memory module, a second inter-memory-module interconnection interface that is of the second memory module and is configured to connect to the first memory module, and a connection between the second memory module and the first memory module through the second inter-memory-module interconnection interface.

43. The method according to claim 42, further comprising:
when the destination address of the access request received by the memory controller is located at the second memory module and the second memory channel accessing the second memory module is busy, sending, by the memory controller, the access request to the second memory module through the first memory channel accessing the first memory module, a first inter-memory-module interconnection interface that is of the first memory module and is configured to connect to the second memory module, and a connection between the first memory module and the second memory module through the first inter-memory-module interconnection interface.

44. A computer system, comprising: at least one memory controller, a first memory module, and a second memory module, wherein the memory modules are connected to the memory controller;
the first memory module is provided with a first memory channel interface, and connected to a first memory channel through the first memory channel interface; and the second memory module is provided with a second memory channel interface, and connected to a second memory channel through the second memory channel interface, the first memory module is connected to the memory controller through the first memory channel, and the second memory module is connected to the memory controller through the second memory channel; and
the first memory module and the second memory module each are further provided with a first inter-memory-module interconnection interface, and the first inter-memory-module interconnection interface of the first memory module and the first inter-memory-module interconnection interface of the second memory module are connected.

45. The system according to claim 44, wherein the first memory module is configured to receive or send access data through the second memory channel and a connection between the first inter-memory-module interface of the first memory module and the first inter-memory-module interconnection interface of the second memory module; and receive or send access data through the first memory channel.

46. The system according to claim 45, wherein the access data comprises one or more of the following: an access request for the first memory module, response data or association data of the access request for the first memory module, an access request for the second memory module, and response data or association data of the access request for the second memory module.

47. The system according to any one of claims 44 to 46, wherein the first memory module comprises a first memory management unit and at least one storage unit, wherein the first memory management unit is connected to the first inter-memory-module interconnection interface, the first memory channel interface, and the storage unit, and the first memory management unit is configured to:
receive access data through the first memory channel interface;
determine, according to the access data, whether a destination memory module of the access data is the first memory module;
send the access data to the second memory module through the first inter-memory-module interconnection interface, if the destination memory module of the access data is not the first memory module; and
determine, according to the access data, a destination storage unit associated with the access data, if the destination memory module of the access data is the first memory module, and execute an operation on the destination storage unit according to the access data, wherein the destination storage unit is one or more of storage units of the first memory module.

48. The system according to claim 47, wherein the first memory management unit is further configured to: receive access data through the first inter-memory-module interconnection interface, and determine a destination storage unit associated with the access data; and execute an operation on the destination storage unit according to the access data.

49. The system according to claim 45, wherein the system further comprises a third memory module, wherein the third memory module is provided with a third channel interface; and the first memory module and the third memory module each are further provided with a second inter-memory-module interconnection interface, and the second inter-memory-module interconnection interface of the first memory module and the second inter-memory-module interconnection interface of the third memory module are connected;
the third memory module is connected to a third memory channel or the second memory channel through the third channel interface; and
the first memory module is further configured to receive or send access data for the memory system through the third memory channel and a connection between the second inter-memory-module interconnection interface of the first memory module and the second inter-memory-module interconnection interface of the third memory module.

50. The system according to claim 49, wherein the access data comprises one or more of the following: an access request for the first memory module, response data or association data of the access request for the first memory module, an access request for the second memory module, response data or association data of the access request for the second memory module, an access request for the third memory module, and response data or association data of the access request for the third memory module.

51. The system according to claim 49 or 50, wherein the first memory module comprises a first memory management unit and at least one storage unit, wherein the first memory management unit is connected to the first inter-memory-module interconnection interface, the second inter-memory-module interconnection interface, the first memory channel interface, and the storage unit, and the first memory management unit is configured to:
receive access data through the first memory channel interface;
determine, according to the access data, whether a destination memory module of the access data is the first memory module;
determine, according to correspondence between a destination address of the access data and the inter-memory-module interconnection interface, an inter-memory-module interconnection interface corresponding to the access data, if the destination memory module of the access data is not the first memory module; send the access data to the second memory module through the first inter-memory-module interconnection interface, if the inter-memory-module interconnection interface corresponding to the access data is the first inter-memory-module interconnection interface; and send the access data to the third memory module through the second inter-memory-module interconnection interface, if the inter-memory-module interconnection interface corresponding to the access data is the second inter-memory-module interconnection interface; and
determine, according to the access data, a destination storage unit associated with the access data, if the destination memory module of the access data is the first memory module, and execute an operation on the destination storage unit according to the access data, wherein the destination storage unit is one or more of storage units of the first memory module.

52. The system according to any one of claims 44 to 48, wherein
the first memory channel and the second memory channel are connected to a same memory controller.

53. The system according to claim 52, wherein the memory controller is configured to:
monitor a running status of the first memory channel and the second memory channel; and
receive access data for the memory system, and send the access data to the memory system according to the running status of the first memory channel and the second memory channel.

54. The system according to claim 53, wherein the memory controller is specifically configured to:
monitor the running status of the first memory channel and the second memory channel, wherein the running status comprises a busy status and an idle status;
when a destination address of the received access data is located at the first memory module and the first memory channel is busy, the memory controller sends the access data to the second memory module through the second memory channel, and the second memory module sends the access data to the first memory module through the connection between the first inter-memory-module interconnection interface of the second memory module and the first inter-memory-module interconnection interface of the first memory module; and
when the destination address of the received access data is located at the second memory module and the second memory channel is busy, the memory controller sends the access data to the first memory module through the first memory channel, and the first memory module sends the access data to the second memory module through the connection between the first inter-memory-module interconnection interface of the first memory module and the first inter-memory-module interconnection interface of the second memory module.

55. The system according to claim 53 or 54, wherein the memory controller is further configured to: record a path of the access data and a status of the access data, wherein the path of the access data comprises the first memory channel or the second memory channel and the status of the access data comprises whether the access data is sent and/or whether a result of an access request is returned.

56. The system according to any one of claims 44 to 48, wherein
the first memory channel is connected to a first memory controller and the second memory channel is connected to a second memory controller.

57. The system according to claim 56, wherein the first memory controller is connected to a first processor and the second memory controller is connected to a second processor; or the first memory controller is built in a first processor and the second memory controller is built in a second processor.

58. The system according to claim 57, wherein the first processor is disposed on a first board and the second processor is disposed on a second board.

59. The system according to claim 57 or 58, wherein the first processor and the second processor run different operating systems separately.

60. The system according to any one of claims 44 to 59, wherein storage media of the different memory modules are different; or, storage media of different memory modules are the same.

61. The system according to any one of claims 44 to 60, wherein the memory module is an independent physical module, and the memory channel interface and the inter-memory-module interconnection interface are physical interfaces.

62. The system according to any one of claims 44 to 61, wherein the memory channel interface is a double data rate DDR interface or DDR2 interface or DDR3 interface or DDR4 interface.
